Europäisches Patentamt

European Patent Office

Office européen des brevets

(19)

(11) EP 1 215 784 A2

(12) EUROPEAN PATENT APPLICATION

(43) Date of publication:
19.06.2002 Bulletin 2002/25

(51) Int Cl.⁷: H01S 5/40, H01S 5/00,
H01S 5/022, G02B 6/42,
G02B 27/10

(21) Application number: 01129993.0

(22) Date of filing: 17.12.2001

(84) Designated Contracting States:
AT BE CH CY DE DK ES FI FR GB GR IE IT LI LU
MC NL PT SE TR
Designated Extension States:
AL LT LV MK RO SI

(30) Priority: 15.12.2000 JP 2000381936
02.07.2001 JP 2001201513
23.10.2001 JP 2001325706

(71) Applicant: The Furukawa Electric Co., Ltd.
Tokyo 100-8322 (JP)

(72) Inventors:
• Tsukiji, Naoki
Tokyo 100-8322 (JP)
• Yoshida, Junji
Tokyo 100-8322 (JP)
• Funabashi, Masaki
Tokyo 100-8322 (JP)

• Kimura, Toshio
Tokyo 100-8322 (JP)
• Aikiyo, Takeshi
Tokyo 100-8322 (JP)
• Shimizu, Takeo
Tokyo 100-8322 (JP)
• Yamamoto, Toshiro
Tokyo 100-8322 (JP)
• Toratani, Tomoaki
Tokyo 100-8322 (JP)
• Matsuura, Hiroshi
Tokyo 100-8322 (JP)
• Konishi, Mieko
Tokyo 100-8322 (JP)
• Nakae, Masashi
Tokyo 100-8322 (JP)

(74) Representative: Zimmermann, Gerd Heinrich et al
Zimmermann & Partner,
P.O. Box 33 09 20
80069 München (DE)

(54) **Semiconductor laser device for use in a semiconductor laser module and optical amplifier**

(57) A single semiconductor laser device (2) used in a semiconductor laser module of an optical amplifier (48) and having a first light emitting stripe (9) with a dif-fraction grating (75) and at least one other light emitting stripe (10) with a diffraction grating (75) and which are aligned to respectively emit a first laser beam and at least one other laser beam through one edge surface.

Fig.2

EP 1 215 784 A2

**Description**

The present invention relates to a semiconductor laser module, and an optical amplifier using the semiconductor laser module. More particularly the present invention relates to a semiconductor laser device within the semiconductor laser module comprising two laser beams and an optical amplifier making use thereof.

With progress in optical communications based on a high-density wavelength division multiplexing transmission system over the recent years, a higher output is increasingly demanded to a pumping light source used for the optical amplifier.

Further, a greater expectation is recently given to a Raman amplifier as means for amplifying the beams having a much broader band than by an erbium-doped optical amplifier that has hitherto been used as the optical amplifier. The Raman amplification is defined as a method of amplifying the optical signals, which utilizes such a phenomenon that a gain occurs on the side of frequencies as low as about 13 THz from a pumping beam wavelength due to the stimulated Raman scattering occurred when the pumping beams enter an optical fiber, and, when signal beams having the wavelength band containing the gain described above are inputted to the optical fiber in the thus pumped (excited) state, these signal beams are amplified.

According to the Raman amplification, the signal beams are amplified in a state where a polarizing direction of the signal beams is coincident with a polarizing direction of the pumping beams, and it is therefore required that an influence caused by a deviation between polarizing planes of the signal beam and of the pumping beam be minimized. For attaining this, a degree of polarization (DOP) has hitherto been reduced by obviating the polarization of the pumping beam (depolarization).

As a method for simultaneously realizing a higher output and depolarization of a pumping light source, as disclosed in US Patent No. 5589684, a method in which a laser beam emitted from two semiconductor laser modules oscillating on the same wavelength is polarization-synthesized by a polarization synthesizing coupler is known.

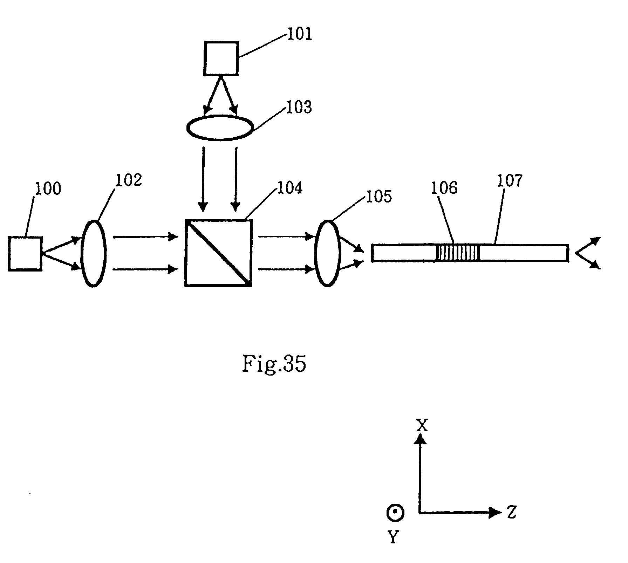

Fig. 35 is an explanatory view in explaining a conventional semiconductor laser apparatus disclosed in US Patent No. 5589684.

As shown in Fig. 35, a conventional semiconductor laser apparatus comprises: a first semiconductor laser device 100 and a second semiconductor laser device 101 for emitting laser beams in the orthogonal direction with each other on the same wavelength; a first collimation lens 102 for collimating the laser beam emitted from the first semiconductor laser device 100; a second collimation lens 103 for collimating the laser beam emitted from the second semiconductor laser device 101; a polarization synthesizing coupler 104 for orthogonally polarization-synthesizing the laser beam collimated by the first collimation lens 102 and the second collimation lens 103; a condenser lens 105 for condensing the laser beams polarization-synthesized by the polarization synthesizing coupler 104; and an optical fiber 107 with a fiber Bragg grating (FBG) 106 for receiving the laser beams condensed by the condenser lens 105 and letting the beams travel to the outside.

According to a conventional semiconductor laser apparatus, since the laser beams emitted in the orthogonal direction with each other from the first semiconductor laser device 100 and the second semiconductor laser device 101 are polarization-synthesized by the polarization synthesizing coupler 104, a laser beam whose degree of polarization is small can be emitted from the optical fiber 107. Furthermore, since fiber Bragg grating 106 is formed in the optical fiber 107, oscillation wavelengths of the semiconductor laser devices 100 and 101 are fixed in the same degree, a laser beam whose wavelength is fixed can be emitted from the optical fiber 107.

Accordingly, the above-mentioned conventional semiconductor laser apparatus can be applied as a pumping light source of an optical amplifier which requires a high optical output, especially of a Raman amplifier, which requires a low polarization dependency and a wavelength stability.

A conventional semiconductor laser apparatus has the following problems.

(1) In the conventional semiconductor laser apparatus, two chip carriers with two semiconductor laser devices 100 and 101 attached thereto respectively need to be disposed on a base plate by soldering. At this time, since positioning need to be conducted so that laser beams emitted from the two semiconductor laser devices 100 and 101 be orthogonal with each other, it is difficult to conduct the positioning of the semiconductor laser devices and a time for positioning becomes longer. As a result, a time for manufacturing a semiconductor laser module is increased.

(2) Since the beams emitted from each of the semiconductor laser devices 100 and 101 are emitted in completely different directions from each other, there arises, for example, a warp of a package in which optical components are aligned and fixed under a state of a high temperature. Due to this, it is difficult to stabilize beam intensity and a degree of polarization of the beam emitted from the optical fiber.

(3) In the conventional semiconductor laser apparatus, since collimation lenses 102 and 103 for collimating the laser beams emitted from the semiconductor laser device 100 are used, a beam diameter and an image magnification are enlarged. Therefore, there is a problem in that a tolerance for the position and angle is strict.

(4) In order to cool the two semiconductor laser devices 100 and 101 positioned at a space, a large-sized Peltier module is required. As a result, there is a problem in that the electric power consumption of a semiconductor laser module is increased.

(5) In the conventional semiconductor laser apparatus, an optical fiber with the fiber Bragg grating 106 and the semiconductor laser devices 100 and 101 need to be optically coupled. Since the optical coupling includes mechanically connected portions to form a resonator, there is a fear that an oscillation characteristic of the laser beam is changed due to a mechanical vibration or a change in temperature. Therefore, there is a problem in that it is impossible to provide a stable optical output in some cases.

(6) Wavelengths of the laser beams emitted from each of the semiconductor laser devices 100 and 101 are determined by a single FBG and thus it is impossible to separately set the wavelength of each semiconductor laser device.

Furthermore, if this semiconductor laser device is used as a pumping light source for the Raman amplification, there are the following problems.

(7) In the conventional semiconductor laser device, the resonance between the fiber Bragg grating 106 and an optical reflection surfaces (rear edge surface of the semiconductor laser devices) creates noise peaks that appear periodically on the freaquency axis of the relativie intensity (RIN) profile. These peaks function to add noise to amplified signals, since amplification occurs at an early stage in the Raman amplification, where the fluctuation in pumping beam intensity is transposed to that in a Raman gain. Therefore, there is a problem in that a stable Raman amplification can not be conducted.

(8) As an optical amplification method, there is a backward pumping in which a pumping beam is supplied in the opposite direction of the traveling direction of the signal beam, a forward pumping in which a pumping beam is supplied in the same direction of the traveling direction of the signal beam and a bidirectional pumping in which pumping beams are supplied in both of the directions. At present, however, only the backward pumping is mainly used in the Raman amplifier, because in the forward pumping, a weak signal beam propagates together with a intense pumping beam in the same direction, making the fluctuation of the pumping beam intensity more likely to be transposed to that of the amplified signal beam than backward pumping. Therefore, there is a demand for a stable pumping light source which can be applied to the forward pumping. In other words, the semiconductor laser module using a conventional fiber Bragg grading has a problem in that applicable pumping methods are limited.

(9) In the Raman amplification, the amplification can take place when the polarizing direction of the signal beams is coincident with the polarizing direction of the pumping beams. That is, in the Raman amplification, there is a polarization dependency of an amplification gain, and an influence due to a deviation between the polarizing direction of the signal beam and the polarizing direction of the pumping beam should be minimized. Here, in the case of the backward pumping, since polarization-of the pumping beam is randomized while propagating in the fiber in the opposite direction to the signal beam, there arises less problem. However, in the case of the forward pumping, polarization dependency is strong and thus the polarization dependency needs to be reduced by orthogonal polarization synthesizing of the pumping beams, depolarization and the like.

In other words, a degree of polarization (DOP) of the pumping beam needs to be minimized. Furthermore, since in Raman amplification, the gain is relatively low, a pumping light source for the Raman amplification having a high output has been demanded.

The present invention intends to overcome the above problems. The object is solved by the semiconductor laser device according to independent claim 1, the single semiconductor laser device according to independent claim 20, the optical amplifier according to independent claim 26 and the semiconductor laser module according to independent claim 32. Further advantages, features, aspects and details of the invention are evident from the dependent claims, the description and the accompanying drawings.

The present invention relates to a semiconductor laser module, and an optional amplifier using the semiconductor laser module. More particularly the present invention relates to a semiconductor laser device within the semiconductor laser module comprising two laser beams and an optical amplifier making use thereof.

In contrast to the prior art, the embodiments of the present invention are for a semiconductor laser module, a manufacturing method thereof and an optical amplifier that are capable of obtaining a high optical coupling efficiency, attaining a down-size and a mass-production, and reducing both of a manufacturing time and a manufacturing cost. More particularly the present invention relates to a semiconductor laser device provided with two stripes from which two laser beams are emitted, and an optical amplifier.

The present invention provides a semiconductor laser device having a plurality of stripes formed at a space, wherein laser beams are emitted from one-sided edge surfaces of the respective stripes and diffraction gratings are provided in the respective stripes.

In particular, the present invention provides a semiconductor laser device comprising a first light emitting stripe aligned to emit a first laser beam through one edge surface and at least one other light emitting stripe aligned to emit at least one other laser beam through the one edge surface, wherein the first light emitting stripe aligned to emit the first laser beam through the one edge surface and an opposite edge surface and the least one other light emitting stripe aligned to emit at the least one other laser beam through the one edge surface and the opposite edge surface.

A more complete appreciation of the invention and many of the attendant advantages thereof will be readily obtained as the same becomes better understood by reference to the following detailed description when considered in connection with the accompanying drawings, wherein:

FIG. 1(A) is a side sectional view showing a configuration of a semiconductor laser module in accordance with a first embodiment of the present invention; FIG. 1(B) is a side view showing a state where a semiconductor laser device is fixed onto a heat sink;

FIG. 2 is an explanatory diagram schematically showing a configuration of the semiconductor laser module in accordance with the first embodiment of the present invention;.

FIG 3(A) is a side view showing a configuration of a prism; FIG 3(B) is a plan view thereof;

FIG 4(A) is a plan view showing a polarization synthesizing module; FIG. 4(B) is a side sectional view thereof; FIG 4(C) is a front view thereof;

FIG 5 is a graph showing a spectrum when a drive current 2A (1A applied per stripe) is applied in a double-stripe type semiconductor laser module;

FIG 6 is a graph showing a fiber output versus an LD drive current in the double-stripe type semiconductor laser module;

FIGS. 7(A) and 7(B) are explanatory diagrams showing a step of aligning a first lens;

FIGS. 8(A) to 8(C) are explanatory views showing a configuration of the semiconductor laser device; FIGS. 8(B) and 8(C) are sectional views each taken along the line a-a in FIG. 8(A);

FIG. 9 is an explanatory view showing another example of the semiconductor laser device;

FIG 10 is an explanatory diagram schematically showing a configuration of the semiconductor laser module in accordance with a second embodiment of the present invention;

FIG 11 is an explanatory diagram schematically showing a configuration of the semiconductor laser module in accordance with a third embodiment of the present invention;

FIG 12 is a fragmentary perspective view showing a polarization synthesizing module in accordance with a fourth embodiment of the present invention;

FIG. 13 is a side sectional view showing the polarization synthesizing module shown in FIG 12;

FIG 14 is an explanatory diagram schematically showing a semiconductor laser device in accordance with the fifth embodiment of the present invention;

FIGS. 15(A) to 15(C) are explanatory views showing a configuration of the semiconductor laser device in accordance with a sixth embodiment of the present invention; FIGS. 15(B) and 15(C) are a sectional view taken along the line b-b in FIG 15(A) and a sectional view taken along the line c-c in FIG 15(A), respectively;

FIG 16 is a graph showing a relationship between an oscillation spectrum and oscillation longitudinal modes in the semiconductor laser device in accordance with the sixth embodiment of the present invention;

FIGS. 17(A) and (B) are graphs showing a relationship in laser optical output power between a single oscillation longitudinal mode and a plurality of oscillation longitudinal modes, and a threshold value of stimulated Brillouin scattering;

FIGS. 18(A) to 18(C) are vertical sectional views each showing in the longitudinal direction a configuration of the semiconductor laser device in accordance with a seventh embodiment of the present invention;

FIG 19 is a vertical sectional view showing in the longitudinal direction a configuration of the semiconductor laser device in accordance with an eighth embodiment of the present invention;

FIG 20 is an explanatory diagram showing a fluctuation in period of diffraction gratings provided in the semiconductor laser device shown in FIG. 19;

FIG 21 (A) to 21 (C) are an explanatory diagrams showing a modified example for actualizing the fluctuation in period of the diffraction gratings provided in the semiconductor laser device shown in FIG 19;

FIG 22 (A) to 22 (B) are an explanatory diagrams schematically showing a configuration of the semiconductor laser module in accordance with an eleventh embodiment of the present invention;

FIG 23 is an explanatory diagram schematically showing a configuration of the semiconductor laser module in accordance with a twelfth embodiment of the present invention;

FIG 24 is an explanatory diagram schematically showing a configuration of the semiconductor laser module in accordance with a thirteenth embodiment of the present invention;

FIG 25 is an explanatory diagram schematically showing a configuration of the semiconductor laser module in accordance with a fourteenth embodiment of the present invention;

FIG 26 (A) to 26 (C) are an explanatory diagrams showing an example of a photo diode (light receiving element) in accordance with a fifteenth embodiment of the present invention;

FIG 27 (A) to 27 (B) are an explanatory diagrams schematically showing a configuration of the semiconductor laser module in accordance with a sixteenth embodiment of the present invention;

FIG 28 is a graph showing a beam transmissivity when entering a wavelength selection filter 7a;

FIG. 29(A) to 29(B) are an explanatory diagrams schematically showing a configuration of the semiconductor laser module in accordance with a seventeenth embodiment of the present invention;

FIG 30 is an explanatory diagram showing a wedge-shaped prism;

FIG 31(A) to 31(B) are an explanatory diagrams showing a optical path correction prism;

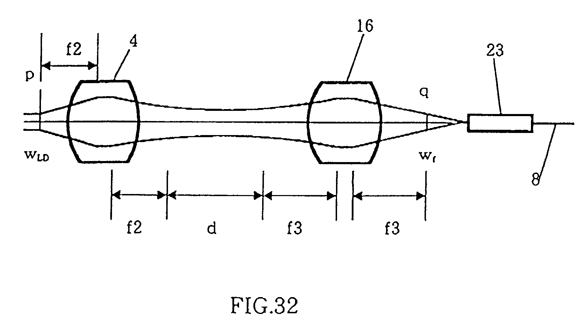

FIG 32 is an explanatory diagram showing coupling of Gaussian beams;

FIG 33 is a block diagram showing a configuration of a Raman amplifier in accordance with a eighteenth embodiment of the present invention;

FIG 34 is a block diagram showing an architecture of a WDM communication system to which the Raman amplifier shown in FIG 33 is applied.

FIG.35 is a explanatory diagram showing a semiconductor laser module as disclosed in USP5,589,684.

Embodiments of the present invention will hereinafter be described with reference to the accompanying drawings.


(First Embodiment)

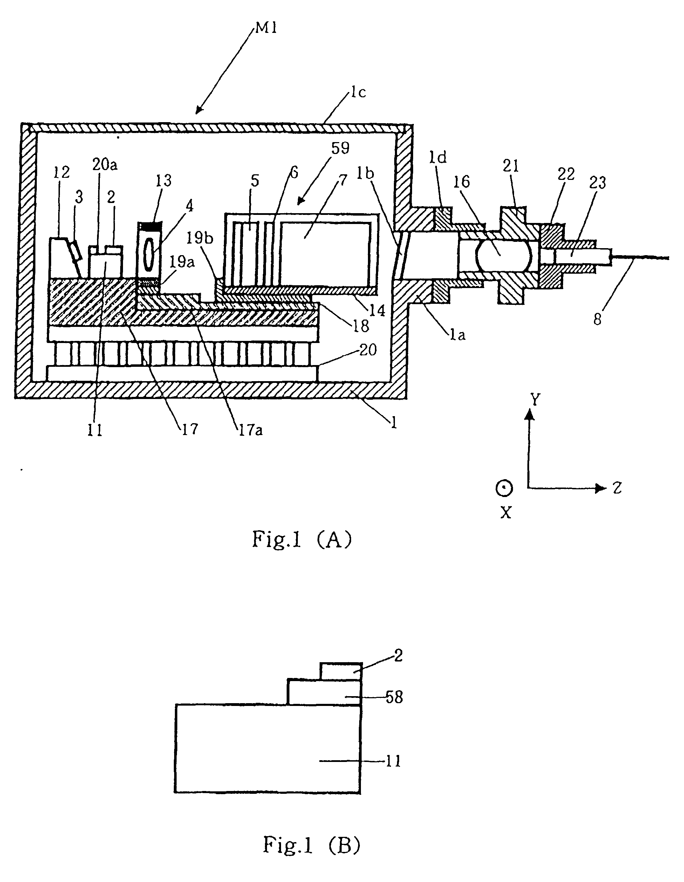

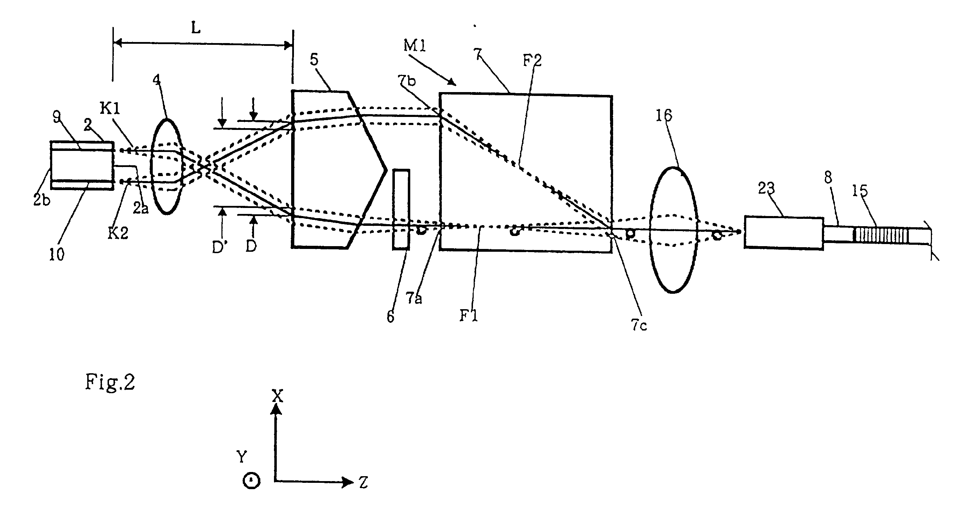

FIG. 1(A) is a side sectional view showing a configuration of the semiconductor laser module in accordance with a first embodiment of the present invention. FIG 2 is an explanatory diagram schematically showing the configuration of the semiconductor laser module in accordance with the first embodiment of the present invention.

As shown in FIG 1(A), a semiconductor laser module M1 in accordance with the first embodiment of the present invention includes a package 1 of which an interior is hermetically sealed, a semiconductor laser device 2, encased in the package 1, for emitting laser beams, a photo diode (a light receiving element) 3, a first lens 4, a prism 5, a half-wave plate (a polarization rotating element) 6, a PBC (polarization beam combiner) 7 serving as an optical synthesizing element and an optical fiber 8.

The semiconductor laser device 2 includes, as shown in FIG. 2, a first stripe 9 (a stripe-shaped light emitting portion) and a second stripe 10 disposed with an interval on the same plane and extending in parallel in the longitudinal direction. The semiconductor laser device 2 emits a first laser beam K1 and a second laser beam K2 respectively from edge surfaces of the first and second stripes 9, 10. K1 and K2 shown in FIG 2 represent trajectories of the centers of the beams that exit the first and second stripes 9, 10, respectively. The beam travels, as indicated by a broken line in FIG. 2, with some divergence (spread) about the center thereof. A space between the first stripe 9 and the second stripe 10 is set as 100 µm or less e.g., approximately 40-60 µm in order for the beams K1, K2 exiting these stripes 9, 10 to enter one piece of first lens 4. Moreover, the space between the stripes is narrow, whereby a difference in optical output characteristic between the stripes decreases.

As shown in FIG 1(A), the semiconductor laser device 2 is fixedly fitted onto a chip carrier 11. Note that the semiconductor laser device 2 emits the two laser beams K1, K2 and is therefore easier to become exothermic than a semiconductor laser device for emitting the single laser beam. It is therefore preferable that the semiconductor laser device 2 be fixedly fitted onto a heat sink 58 composed of a material exhibiting a high thermal conductivity such as diamond and so forth, and that the heat sink 58 be fixedly fitted onto the chip carrier 11.

The photo diode 3 receives a monitor-oriented laser beam emitted from a rear (left side in FIG 1(A)) edge surface 2b (see FIG 2) of the semiconductor laser device 2. The photo diode 3 is fixedly attached to a photo diode carrier 12.

The first and second laser beams K1, K2 exiting a front (right side in FIG. 1(A)) edge surface 2a of the semiconductor laser device 2 are incident upon the first lens 4. The first lens 4 functions so that these laser beams K1, K2 travel therethrough and intersect each other to subsequently split and expand in the arrayed direction of the stripes 9 and 10, and focuses these beams at different focal position F1, F2, respectively (see FIG 2).

Normally, parallel beams transformed into a large spot size have an angular tolerance that is as strict as 0.1° or smaller, however, the angular tolerance slackens in the condensing optical system which converges the laser beams at focal positions F1, F2 as described above. Since the first lens 4 is disposed as a condensing optical system in this embodiment, a manufacturing and positioning tolerance of the optical elements, as well as an angular adjusting tolerance of a beam are slack. This is a preferable aspect.

As shown in FIG 1(A), the first lens 4 is held by a first lens holding member 13. As shown in FIG 2, the first lens 4 is preferably positioned so that the optical axis of the first laser beam K1 emerging from the first stripe 9 and the optical axis of the second laser beam K2 emerging from the second stripe 10 show substantially a symmetry about the central axis of the first lens 4. With this arrangement, both of the first and second laser beams K1, K2 travel through the vicinity of the central axis of the first lens 4 that is defined as an area with a small aberration, and hence there is a decreased scatter on the wave surfaces of the laser beams, with the result that the optical coupling efficiency to the optical fiber 8 rises. As a result, a higher optical output may be obtained from the semiconductor laser module M1. Note that the first lens 4 preferably involves the use of an aspherical lens exhibiting a small spherical aberration for a high coupling efficiency to the optical fiber to be obtained.

The prism 5 is disposed between the first lens 4 and the PBC 7 and adjusts the optical paths, substantially collimates the optical axes, of the first and second laser beams K1, K2, thus letting the laser beams K1, K2 exit the prism 5 itself. The prism 5 is composed of an optical glass of BK7 (borosilicate crown glass) and so on. The optical axes of the first and second laser beams K1, K2 traveling in non-parallel from the first lens 4 are collimated by refraction of the prism 5, and hence the forming of the PBC 7 disposed in rear of the prism 5 is facilitated and it becomes feasible to downsize the semiconductor laser module M1 by downsizing the PBC 7.

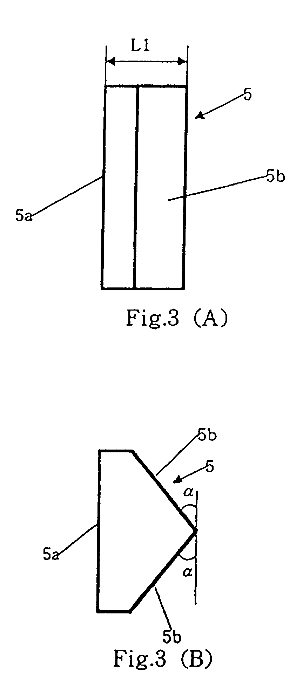

FIG. 3(A) is a side view showing a configuration of the prism 5, and FIG. 3(B) is a plan view thereof. In FIGS. 3(A) and 3(B), the prism 5 includes an incident surface 5a formed flat and exit surfaces 5b inclined at a predetermined angle $\alpha$. For example, the prism 5 may be formed of BK7, the entire length L1 thereof may be approximately 1.0mm, and $\alpha$ may be designed to be $3.2° \pm 0.1°$, for the case of the stripes being spaced by 40µm, and the focal length of the first lens being chosen to be 0.7mm.

As shown in FIG 2, the half-wave plate 6 admits an incidence of only the first laser beam K1 of the first and second laser beams K1, K2 passing through the prism 5, and rotates by 90 degrees a polarizing surface of the first laser beam K1 incident thereupon. The first lens 4 splits the first and second laser beams K1, K2 widely enough for the half-wave plate 6 to be able to be disposed easily.

The PBC 7 has a first input part 7a on which the first laser beam K1 is incident, a second input part 7b on which the second laser beam K2 is incident, and an output part 7c where the first laser beam entering the first input part 7a and the second laser beam K2 entering the second input part 7b are multiplexed (synthesized) and thus exit. The PBC 7 may be, for instance, a birefringence element through which the first laser beam K1 travels as an ordinary ray to the output part 7C and the second laser beam K2 travels as an extraordinary ray to the output part 7c. The PBC 7, if being the birefringence element, may be composed of, e.g., rutile ($TiO_2$) to obtain a high index of birefringence and a large split width between the laser beams.

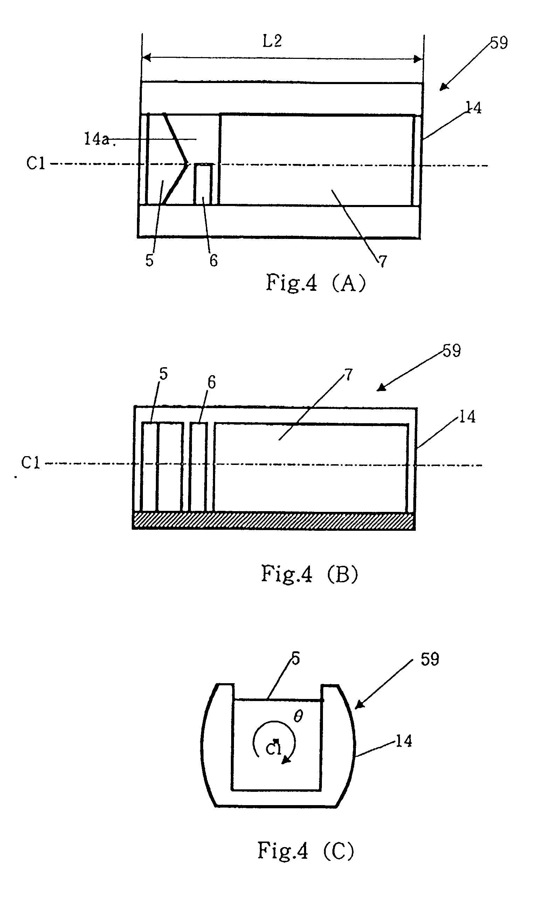

In the first embodiment, a polarization synthesizing module 59 is adopted in which the prism 5, the half-wave plate 6 and the PBC 7 are fixed to the same holder member 14. FIG 4(A) is a plan view showing the polarization synthesizing module 59. FIG. 4(B) is a side sectional view thereof. FIG. 4(C) is a front view thereof. As shown in FIGS. 4(A) to 4(C), the holder member 14 of the polarization synthesizing module 59 is composed of a material (for example, SUS403, SUS304 and so on) suitable for YAG laser welding. The holder member 14 is approximately 7.0 mm in its entire length L2 and is formed substantially in a cylindrical shape as a whole. The holder member 14 is formed inside with an rectanguler accommodation space 14a in which the prism 5, the half-wave plate 6 and the PBC 7 are fixedly provided, respectively. The holder member 14 is opened at its upper portion and is flat in its lower portion.

This configuration greatly facilitates adjusting the positions of the prism 5 and the PBC 7 about a central axis C1 so that both of the first laser beam K1 incident upon the first input part 7a of the PBC 7 and the second laser beam K2 incident upon the second input part 7b thereof, exit the output part 7c.

Thus, these optical elements are set integral within the holder member 14, and it is therefore possible to adjust a degree of how much the laser beams K1, K2 overlap with each other on the X-Y plane simply by moving the holder member 14.

As shown in FIG 2, the optical fiber 8 receives the laser beams exiting the output part 7c of the PBC 7 and lets the laser beams travel outside the package 1. The optical fiber 8 is, as shown in FIG 2, provided with a beam reflection element 15 consisting of an FBG (fiber bragg grating) that reflects the beams having a predetermined wavelength range. This beam reflection element 15 reflects the beams having the predetermined wavelength back to the semiconductor laser device 2. With this beam reflection element 15, an oscillation wavelength of the semiconductor laser device 2 is fixed, and an oscillation spectral width can be decreased. Accordingly, the laser beams emitted from the semiconductor laser modules M1 can be multiplexed with decreased loss at wavelength synthesizing coupler, and therefore, high output, multiplexed beams can be obtained which is suitable for use as a pumping light source of an erbium doped optical amplifier or a Raman amplifier. If used for a Raman amplifier, a fluctuation in gain of the Raman amplification can be restrained. The beam reflection element 15 is formed by irradiating a core of the optical fiber 8 with ultraviolet rays serving as interference fringes through, e.g., a phase mask, and consequently causing periodic changes in refractive index.

A second lens 16 for optically coupling the laser beams emerging from the output part 7c of the PBC 7 to the optical fiber 8, is disposed between the PBC 7 and the optical fiber 8. Preferably, the first lens 4 is positioned so that the first and second laser beams K1, K2 are focused on points (F1, F2) between the first lens 4 and the second lens 16. With this contrivance, a propagation distance L needed for the first and second laser beams K1, K2 to split widely enough for a half wave plate 6 to be able to be inserted only on the beam path of K1 (in other words, for a distance D' in FIG. 2 to take a sufficiently large value) is increased, because of the reduced beam spot sizes between the first lens 4 and focal points (F1, F2) which reduces overlapping of the two laser beams. Hence, a length of the semiconductor laser module M1 in the optical-axis direction can be reduced. As a result, it is feasible to provide the highly reliable semiconductor laser module M1 exhibiting an excellent stability over time of the optical coupling of the semiconductor laser device 2 to the optical fiber 8 under, e.g., a high-temperature environment.

As shown in FIG 1, the chip carrier 11 to which the semiconductor laser device 2 is fixed and the photodiode carrier 12 to which the photo diode 3 is fixed, are fixed by soldering onto a first base plate 17 taking substantially an L-shape in section. It is preferable that the first base plate 17 be composed of a CuW based alloy and so on in order to enhance a capacity of transferring the heat evolved by the semiconductor laser device 2.

The first lens holding member 13 to which the first lens 4 is fixed and the polarization synthesizing module 59 with the prism 5, the half-wave plate 6 and the PBC 7 fixed to the holder member 14, are fixed by the YAG laser welding onto a second base plate 18 through a first support member 19a and a second support member 19b, respectively. It is therefore preferable that the second base plate 18 be formed of a stainless steel etc showing a high welding property. Further, the second base plate 18 is fixed by brazing onto a flat part 17a of the first base plate 17.

A cooling device (thermo-electric cooler) 20 constructed of a plurarity of Peltier elements are provided under the first base plate 17. A thermistor 20a provided on the chip carrier 11 detects a change in temperature due to the heat transferred from the semiconductor laser device 2. The cooling device 20 is controlled to keep constant the temperature detected by the thermistor 20a. This contrivance makes it feasible to increase and stabilize the output of emission of the laser beams from the semiconductor laser device 2.

A window 1b upon which the beams penetrating the PBC 7 are incident is provided inside the flange 1a formed at the side area of the package 1, and a second lens 16 for converging the laser beams is fixed at the end of the flange 1a. The second lens 16 is held by a second lens holding member 21 fixed by the YAG laser welding to a side edge of the flange 1a. A metallic slide ring 22 is fixed by the YAG laser welding to a side edge of the second lens holding member 21.

The optical fiber 8 is held by a ferrule 23 fixed by the YAG laser welding to an interior of the slide ring 22.

Next, operations of the semiconductor laser module M1 in accordance with the first embodiment of the present invention will be explained.

As shown in FIG 2, the first and second laser beams K1, K2 emitted from the front edge surfaces 2a of the first and second stripes 9, 10 of the semiconductor laser device 2, penetrate the first lens 4 and intersect each other. Thereafter, the laser beams K1, K2 having a sufficient divergence split thoroughly and then enter the prism 5. A width of divergence (D) between the first and second laser beams K1, K2 when entering the prism 5 is approximately 460μm. The first and second laser beams K1, K2 are collimated by the prism 5 and thus exit (the width of divergence between the laser beams K1 and K2 becomes approximately 500μm at the exit). Then, the first laser beam K1 impinges on the half-wave plate 6 and, after its polarization plane has been rotated by 90 degrees, enters the first input part 7a of the PBC 7, while the second laser beam K2 enters the second input part 7b of the PBC 7.

In the PBC 7, the first laser beam K1 emerging from the first input part 7a and the second laser beam K2 emerging from the second input part 7b, are multiplexed and exit the output part 7c.

The laser beams emitted from the PBC 7 are converged by the second lens 16, then incident upon the edge surface of the optical fiber 8 held by the ferrule 23, and propagate outside. Further, some proportion of the laser beams are reflected by the beam reflection element 15 of the optical fiber 8 back to the semiconductor laser device 2, thereby forming an external resonator between the rear edge surface 2b of the semiconductor laser device 2 and the beam reflection element 15. Hence, the laser oscillations with a wavelength determined by the beam reflection element 15 can occur.

The monitor-oriented laser beams emerging from the rear edge surface 2b of the semiconductor laser device 2, are received by the photo diode 3. An optical output or the like of the semiconductor laser device 2 is adjusted by changing the driving current applied to the semiconductor laser device 2 based on a light receiving quantity etc. of the photo diode 3.

According to the semiconductor laser module M1 in accordance with the first embodiment of the present invention, the first and second laser beams K1, K2 with their polarization planes coincident with each other are emitted from the first and second stripes 9, 10 formed at the space as narrow as 100 μm or less in the single semiconductor laser device 2. The first and second laser beams K1, K2 are thoroughly split from each other by the first lens 4, and thereafter the polarization plane of the first beam is rotated exactly by 90 degrees with the half-wave plate 6. Namely, the polarization planes of the laser beams K1, K2 make substantially completely 90° at this time. The first and second laser beams K1, K2 are polarization-synthesized by the PBC 7 in this state, and hence the laser beams having the high output and a small degree of polarization can be emitted out of the optical fiber 8. Further, the optical fiber 8 is formed with a beam reflection element 15 such as FBG, and therefore the laser beams with a fixed wavelength can be emitted out of the optical fiber 8. Accordingly, the semiconductor laser module M1 can be applied for the pumping light source for an erbium-doped optical amplifier of which a high output is demanded or for a Raman amplifier which is required to have a low polarization dependency of gain and a high gain stability.

Further, since the semiconductor laser module M1 uses one piece of semiconductor laser device 2 formed with two stripes for emitting two fluxes of laser beams and one piece of first lens 4 for splitting the two laser beams, it takes less time to position the semiconductor laser device 2 and the first lens 4. As a result, it is possible to reduce the time for manufacturing the semiconductor laser module M1.

Moreover, there has hitherto been the semiconductor laser module as disclosed in USP5,589,684, in which two pieces of semiconductor lasers emit the laser beams in the axial directions completely orthogonal to each other (refer to FIG.35). This type of semiconductor laser module is, however, if designed without taking a warp or the like of the package in the axial directions (a X direction and a Z direction in FIG.35) into account, incapable of restraining fluctuations in the optical output due to the warp of the package that arises in high temperature environment. By contrast, according to the configuration in the first embodiment, the two laser beams emitted from the single semiconductor laser device 2 travel substantially in the same direction, and hence the optical output of the laser beams emerging from the optical fiber 8 can be stabilized by restraining an influence of the warp of the package only in one direction (a Z-direction in FIG. 2).

Further, the single semiconductor laser device 2 emits the two laser beams, and the coupling efficiencies of these two laser beams have the same tendency of fluctuations with respect to the package warp and so on. Accordingly, the degree of polarization of the laser beams emitted from the optical fiber 8 is stable over the temperature fluctuation.

Further, since the semiconductor laser module M1 uses a single semiconductor laser device 2, it is possible to_downsize the cooling device 20 (e.g. a Peltier module) and to decrease the of electric power consumption.

Note that the electric power consumed when the cooling device 20 radiates a tremendous quantity of heat from the two stripes 9, 10 can be reduced to a large extent by creating a vacuum or filling Xe in the interior of the package 1.

Moreover, if a polarization maintaining fiber formed with the fiber Bragg grating (FBG) is attached to the semiconductor laser module emitting the two fluxes of laser beams ("double-stripe type semiconductor laser module") as in the first embodiment, more longitudinal modes can be contained within the spectral width than in the case of the single-stripe type semiconductor laser module emitting one flux of laser beam with the same magnitude of reflection bandwidth of FBG.

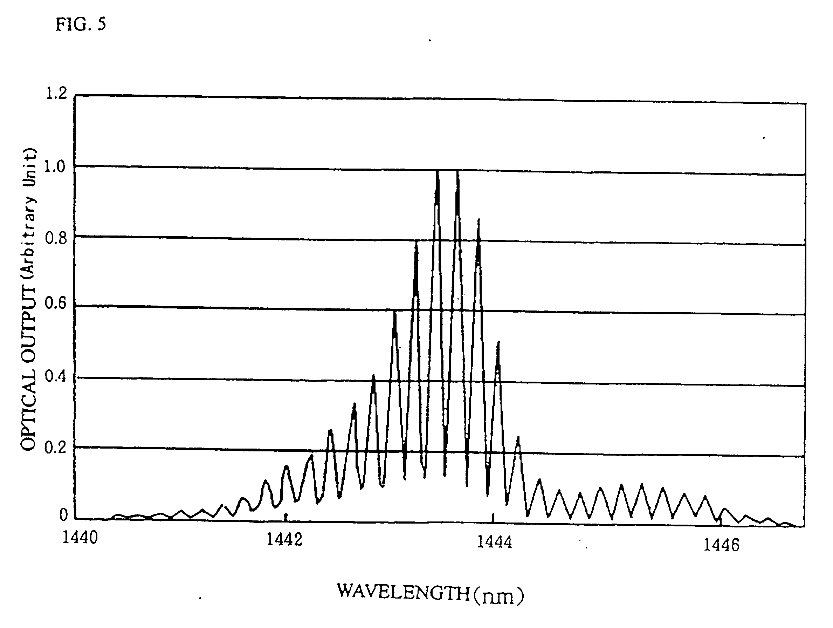

Foe instance, FIG 5 is a graph showing an oscillation spectrum when applying a drive current of 2A (1A per stripe) to the double-stripe type semiconductor laser module M1. As can be understood from FIG 5, five longitudinal modes are contained within the full width at half maximum (FWHM) of the spectrum of the double-stripe type semiconductor laser module M1. On the other hand, in the case of a single-stripe type semiconductor laser module, three or four longitudinal modes are contained within the FWHM of the oscillation spectrum at the drive current 1 A.

Since the polarization maintaining fiber has a refractive index that differs depending on a slow-axis and a fast-axis, the reflection wavelengths selected in the two axes at the FBG differ from each other by about 0.4 nm. Hence, the spectrums from the two stripes, each emitting a spectrum different from the other by about 0.4nm, overlap to contain an increased number of longitudinal modes within the FWHM of the synthesized spectrum.

Note here that the semiconductor laser module according to this embodiment of the present invention emits a polarization-synthesized laser beam with lower DOP than laser beam from a single stripe. In case, however, that DOP is not sufficiently reduced, a output beam might be further depolarized by being transmitted through a length of a polarization maintaining fiber (depolarizer). Then, since the semiconductor laser module according to this embodiment oscillates in an increased number of longitudinal modes, the DOP can be effectively reduced while propagating through the depolarizer. Therefore the semiconductor laser module M1 is suitable as the pumping light source of Raman amplifiers which are required to have the low polarization dependency of gain.

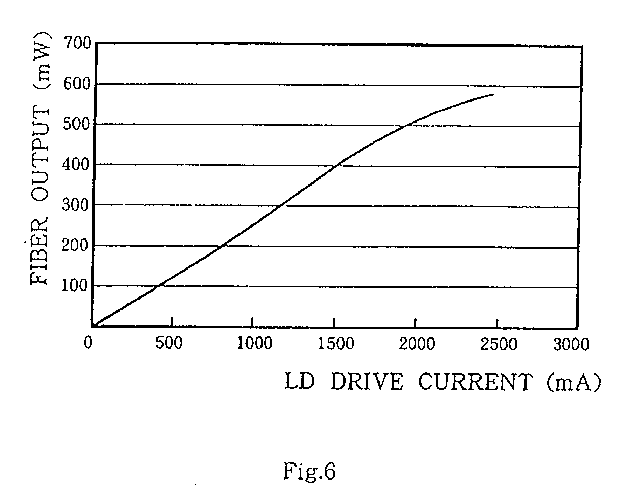

Further, the double-stripe type semiconductor laser module is capable of obtaining high optical output. FIG. 6 is a graph showing a fiber output versus a drive current to the semiconductor laser device in the double-stripe type semiconductor laser module. As can be understood from FIG 6, an eoptical output reaches 570 mW at the drive current is 2400 mA. Hence, the double-stripe typ semiconductor laser module in the first embodiment is suitable for use as a pumping light source in a band of 14XX (1300 to 1550) nm for Raman amplifiers, and also as the pumping light source in bands of 980 nm and 1480 nm for eibium doped fiber amplifiers (EDFA), both of which are required to have high optical output.

Next, a method of manufacturing the semiconductor laser module M1 in accordance with the first embodiment of the present invention will hereinafter be described.

To start with, the second base plate 18 is fixed by brazing onto the flat part 17a of the first base plate 17.

Subsequently, the chip carrier 11 to which the semiconductor laser device 2 is fixed and the photodiode carrier 12 to which the photo diode 3 is fixed, are fixed by soldering onto the first base plate 17.

Next, the first lens 4 is aligned and fixed onto the second base plate 18. In the aligning step of the first lens 4, the semiconductor laser device 2 is supplied with the electric current and emits the first and second laser beams K1, K2 from both of the first and second stripes 9, 10 of the semiconductor laser device 2. Then, after setting this beam emitting direction as a fiducial direction, the first lens 4 is inserted and positioned in the X-, Y- and Z-axis directions.

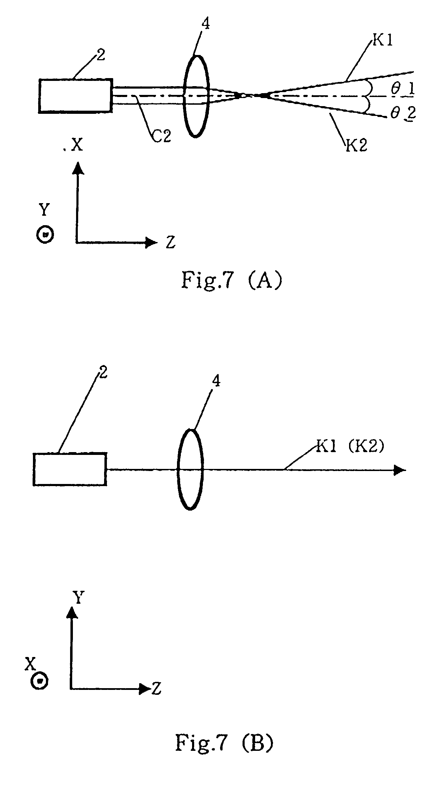

FIGS. 7 (A) and 7(B) are explanatory diagrams showing the aligning step of the first lens 4. The first lens 4 is, as shown in FIG 7(A), positioned in the X-axis direction so that an angle θ1 made between the fiducial direction (a central axis C2) set in the way described above and the first laser beam K1 is equal to an angle θ2 made between the central axis C2 and the second laser beam K2. The first lens 4 is, as shown in FIG 7(B), positioned in the Y-axis direction so that the first and second laser beams K1, K2 travel through the center of the first lens 4. Further, the first lens 4 is positioned in the Z-axis direction so that a spot size of the laser beam is minimized at a predetermined distance from the semiconductor laser device 2. The first lens holding member 13, which holds the first lens positioned in the aligning step described above, is fixed by the YAG laser welding onto the second base plate 18 through the first support member 19a.

Subsequently, the polarization synthesizing module 59 including the prism 5, the half-wave plate 6 and the PBC 7 as the integral unit on the whole, is aligned and fixed onto the second base plate 18. In this aligning step of the polarization synthesizing module 59, the polarization synthesizing module 59 is aligned in the X- Y- and Z-axis directions and rotated about angle θof the central axis C1 (see FIGS. 4(A) to 4(c)) of the holder member 14 so that an optical intensity of the beams coupled to the fiber collimator for positioning is maximized. The polarization synthesizing module 59 is adjusted in its position and then positioned about the central axis C1 of the holder member 14 by rotating the holder member 14 about the central axis C1 so that both of the first laser beams K1 entering the first input part 7a and the second laser beam K2 entering the second input part 7b, exit the output part 7c.

The polarization synthesizing module 59 is positioned in the Z-axis direction in a way that adjust the degree of how much the laser beams K1, K2 outputted from the PBC 7 overlap with each other on the X-Y plane. For example, the laser beams K1, K2 may completely overlap with each other, or they may partially overlap. In the latter case, if the laser beams K1, K2 have different optical intensities, the optical fiber 8 is aligned so as to receive a larger proportion of laser beam having the smaller optical intensity, thus equalizing the optical intensities of the laser beams K1, K2 entering the optical fiber 8. The degree of polarization can be thereby decreased sufficiently.

The holder member 14 is fixed by the YAG laser welding in the position determined in the aligning step described above onto the second base plate 18 through the second support member 19b.

Subsequently, the first base plate 17 is fixed by soldering onto the cooling device 20 which has been fixed beforehand onto a bottom plate of the package 1.

Then, the semiconductor laser device 2 and the photo diode 3 are electrically connected to leads (not shown) of the package 1 through a metal wires (unillustrated).

Next, a cover 1c is placed over the upper portion of the package 1 in an inert gas (e.g., $N_2$, Xe) atmosphere, and a peripheral edge portion thereof is resistance-welded, thereby hermetically sealing the package.

Subsequently, the second lens 16 is aligned within the X-Y plane and in the Z-axis direction and thus fixed to the flange 1a of the package 1. In this step, the second lens holding member 21 is fixed by YAG laser welding in such a position that the beam emerging from the second lens 16 is parallel to the central axis of the flange 1a of the package 1.

Finally, the optical fiber 8 is aligned and then fixed. In this step, the metallic slide ring 22 is fixed to the side edge of the second lens holding member 21. The slide ring 22 is adjusted in its position within the plane (the X-Y plane) perpendicular to the optical axis of the optical fiber 8 at the edge surface of the second lens holding member 21, and is thereafter fixed by YAG laser welding at a boundary therebetween. The ferrule 23 for holding the optical fiber 8 is fixed by YAG laser welding to an interior of the slide ring 22 in such a position that the beam emission from the optical fiber 8 is maximized. On this occasion, the optical fiber 8 is aligned taking a power balance of the plurality of laser beams to be synthesized into consideration. The position of the optical fiber 8 in the optical-axis direction (the z-axis direction) is thereby fixed.

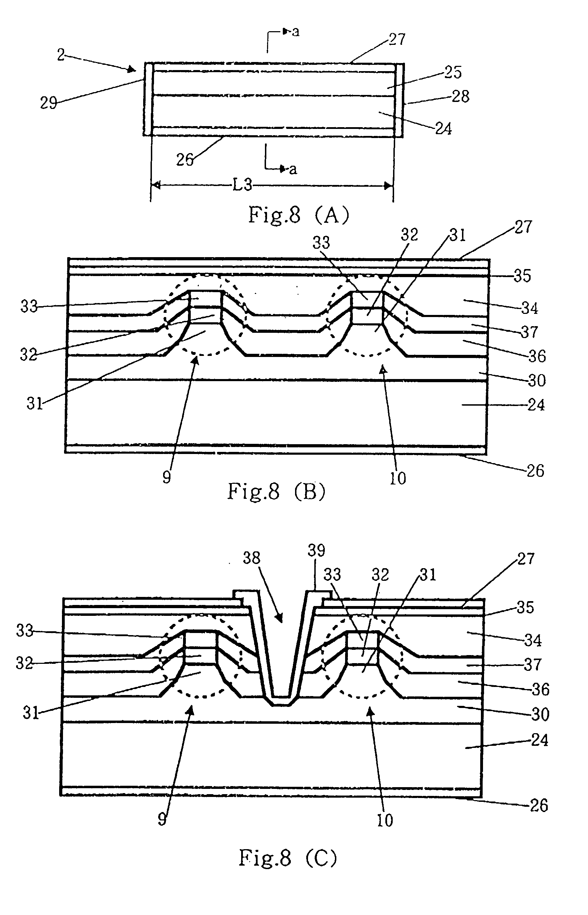

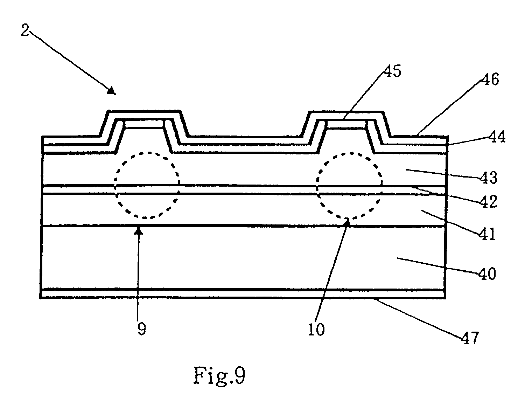

Now, the semiconductor laser device 2 used for the semiconductor laser module in accordance with the first embodiment of the present invention will be explained. FIGS. 8(A) to 8(C) are explanatory views showing the configuration of the semiconductor laser device 2 used for the semiconductor laser module of the present invention. FIG 9 is an explanatory view showing another example of the semiconductor laser device 2. Note that FIGS. 8(B) and 8(C) are the sectional views taken along the line a-a in FIG. 8(A).

As shown in FIG 8(A), the semiconductor laser device 2 is configured such that a lamination structure 25 is formed on a substrate 24 composed of a predetermined semiconductor by executing a predetermined semiconductor epitaxial crystal growth on the basis of a known epitaxial growth technique such as an organic metal vapor phase epitaxy, a liquid phase epitaxy, a molecular beam epitaxy and a gas source molecular beam epitaxy, thereafter a lower electrode 26 is formed on an undersurface of the substrate 24, an upper electrode 27 is formed on an upper surface of the lamination structure 25, a predetermined cavity length L3 is obtained by cleavage, further a low-reflection layer 28 (a reflectance is, e.g., 5% or smaller) is formed on one cleavage surface (the front edge surface 2a), and a high-reflection layer 29 (a reflectance is, e.g., 90% or larger) is formed on the other cleavage surface (the rear edge surface 2b).

As shown in FIG. 8(B), the lamination structure 25 on the substrate 24 is, for instance, a BH (buried hetero) structure wherein e.g. n-InP clad layer 31, an active layer 32 consisting of GRIN-SCH-MQW (Graded Index Separate Confinement Heterostructure Multi Quantum Well) composed of multilayer of GaInAsP, and an p-InP clad layer 33 are sequentially laminated on the substrate composed of e.g., n-InP. And further an upper buried layer 34 composed of, e.g., p-InP and a cap layer 35 composed of, e.g., p-GaInAsP are laminated on the p-InP clad layer 33. Then, the upper electrode 27 and the lower electrode 26 are provided on the cap layer 35 and on the undersurface of the substrate 24, respectively.

The InP clad layer 31, the active layer 32 and the p-InP clad layer 33 are etched to two steaks of stripes arranged in parallel with each other with a space of 40-60 µm, and a current confinement region consisting of a p-InP layer 36 and an n-InP layer 37 are formed on the side faces of the stripes.

The active layer 32 involves, for instance, a compressive strain quantum well structure, wherein a lattice mismatch of well layers with respect to the substrate 24 is 0.5% or larger but is not larger than 1.5%. And the multi quantum well structure of well number of about 5 is preferably used for obtaining a higher output from a stripe. Further, the strained quantum well structure may adopt a strain compensation structure in which a barrier layer thereof takes a tensile strain which is opposite to the strain of the well layer, whereby the lattice match condition can be equivalently met, and a further higher value of the lattice mismatch in the well layer can be tolerated.

According to the first embodiment, the light emitting portions consisting of the n-InP clad layer 31, the GRIN-SCH-MQW active layer 32 and the p-InP clad layer 33 are formed extending in the form of stripes in the direction vertical to the sheet surface in FIG. 8, and these portions are called the stripes 9 and 10, respectively.

Next, a method of manufacturing the semiconductor laser device 2 having the structure described above will be explained.

To begin with, the n-InP clad layer 31, the active layer 32, the p-InP clad layer 33 are laminated in this sequence on the substrate 24 by the known epitaxial growth technique such as the organic metal vapor phase epitaxy, the liquid phase epitaxy, the molecular beam epitaxy and the gas source molecular beam epitaxy.

Subsequently, two pieces of masks arranged in parallel with each other with a space of 40-60µm are provided on the p-InP clad layer 33. Thereafter, some portions of the p-InP clad layer 33, the active layer 32, the n-InP clad layer 31 and the substrate 24, are dissolved by use of a predetermined etchant (etching liquid), and the p-InP blocking layer 36 and the n-InP blocking layer 37 are laminated in this sequence on the sides of the stripes, thereby forming the current confinement region.

Subsequently, the upper buried layer 34 is grown by an epitaxial growth technique.

Further, the cap layer 35 is laminated on the upper buried layer 34.

Next, the upper electrode 27 is formed on the upper surface of the cap layer 35, and the lower electrode 26 is formed on the undersurface of the substrate 24.

Thereafter, the substrate is cleaved into bars with a width L3, thereby defining a cavity with the length L3. The low-reflection layer 28 is formed on one cleavage surface (the front edge surface 2a), and the high-reflection layer 29 is formed on the other cleavage surface (the rear edge surface 2b). Finally the bars are further cleaved into chips to obtain semiconductor laser devices 2.

In the thus manufactured semiconductor laser device 2, the side of the upper electrode 27 is bonded by AuSn-soldering to the heat sink 58 shown in FIG. 1(B). Then, the laser oscillations occur simultaneously at the two stripes when supplied with the electric current from outside via the upper electrode 27 (on the p-side in the first embodiment) and the lower electrode 26 (on the n-side in the first embodiment), and the two fluxes of outgoing beams from the low-reflection layer 28 are multiplexed by the PBC 7 described above to be used for a desired application.

Supposing herein that the two stripes have absolutely the same characteristic, a threshold current of the semiconductor laser device 2 in the first embodiment is twice the threshold current of one single stripe, and the total optical output is twice the optical output of the single stripe. Namely, the semiconductor laser device 2 as a whole obtains approximately a 2-fold optical output with the drive current that is approximately twice the drive current per stripe, and a slope efficiency of the semiconductor laser device 2 is substantially the same as that of the semiconductor laser device 1 having one single stripe.

Note that the first embodiment discussed above has exemplified the structure in which the two stripes are simultaneously driven. As shown in, for example, FIG. 8(C), however, a separation trench 38 having a depth extending from the upper electrode 27 down to the lower clad layer 30, may be formed between the two stripes, and the surface of this separation trench 38 is covered with an insulation layer 39, whereby the two stripes can be electrically separated. If a lower electrode 26 sided portion of the semiconductor laser device 2 described above is bonded by AuSn-soldering to the unillustrated heat sink, the drive currents supplied to the two stripes can be independently controlled, thereby facilitating randomization of the polarization planes of the laser beams emitted from the optical fiber 8. In this case, at least one of the positive electrode side and the negative electrode side of each of the two stripes may be electrically insulated.

Note that the semiconductor laser device 2 as shown in FIG. 8(C) may be used in such a way that a drive current is supplied to only one of the two stripes and the other stripe is supplied with current only after_the active layer of the one stripe falls into an abnormal state. In this case, the other stripe is configured as a redundant system, and hence the semiconductor laser device 2 comes to have a longer product life-span.

Further, if used in a way such that the upper electrode 27 is bonded to the heat sink 58, an electrode may be formed beforehand on the heat sink 58 correspondingly to the upper electrode 27 so that those two stripes can be independently driven.

Further, the semiconductor laser device 2 in the first embodiment discussed above has been exemplified as having the InP-based BH (buried hetero) structure. However, there may also be used the semiconductor laser device 2 of, e.g., a GaAs-based ridge waveguide type as shown in FIG 9. As shown in FIG 9, this semiconductor laser device 2 has a structure in which an n-type lower clad layer 41, an active layer 42, a p-type upper clad layer 43, an insulation layer 44, a p-GaAs layer 45 are laminated on a substrate 40 made of n-GaAs, and two ridges are formed. An upper electrode (p-type electrode) 46 is formed over the insulation layer 44 and the p-GaAs layer 45. A lower electrode (n-type electrode) 47 is formed on an undersurface of the substrate 40.

The ridges are formed extending in stripes in the direction vertical to the sheet surface in FIG 9. Each of the active layer streaks 42 just under along the ridges emits light. These light-emitting layer streaks are called the stripes 9 and 10, respectively. Of course, a InP ridge type LD can be used in this embodiment.

Furthermore, the first embodiment has exemplified the Fabry-Perot semiconductor laser device 2, which is the most basic form of the semiconductor laser device 2. However, the semiconductor laser device 2 may include a wavelength selecting element as will be mentioned later on. When using this type of semiconductor laser device 2, the optical output with a stabilized oscillation wavelength can be obtained without using an optical fiber with FBG.

(Second Embodiment)

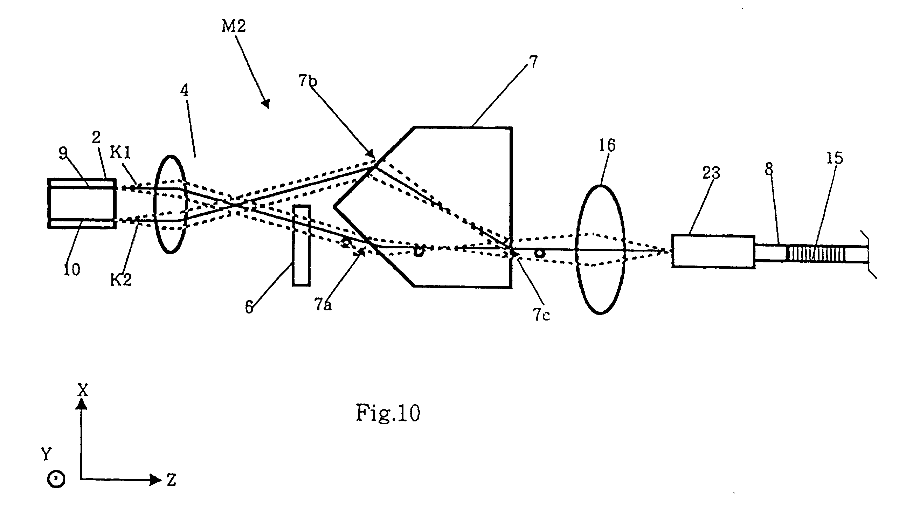

FIG 10 is an explanatory diagram schematically showing a configuration of a semiconductor laser module M2 in accordance with a second embodiment of the present invention. As shown in FIG. 10, according to the second embodiment, incident surfaces of the PBC 7 upon which the first and second laser beams K1, K2 are incident are inclined in a wedge-like shape so that the first laser beam K1 travels as a normal ray in the axial-line direction of the optical fiber 8. Other than this point, this embodiment is substantially the same as the semiconductor laser module in the first embodiment.

According to the second embodiment, the first laser beam K1 travels as the normal ray in the axial-line direction of the optical fiber 8, and hence there is no necessity of providing the prism 5 between the half-wave plate 6 and the first lens 4, thereby making it possible to simplify the configuration and to reduce the length of the semiconductor laser module M2 in the optical-axis direction, making the optical output less susceptible to the warp of the package that arises in a high-temperature environment.

Note that the half-wave plate 6 and the PBC 7, which are fixed to the same holder member 14, may be structured as a polarization synthesizing module in order to facilitate the angular adjustment about the central axis also in the second embodiment.

(Third Embodiment)

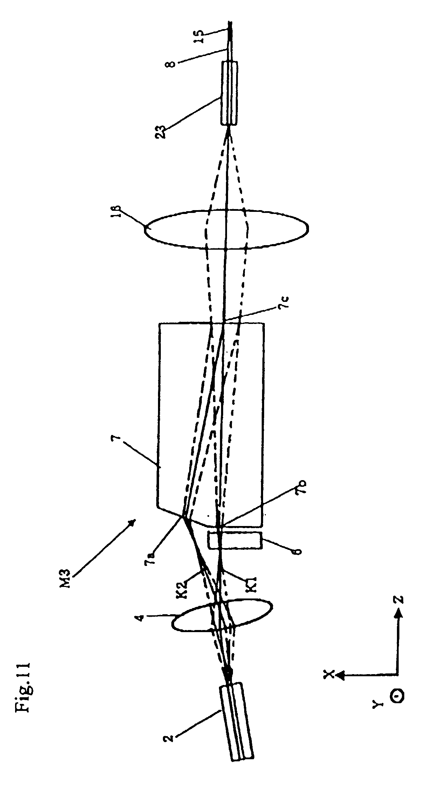

FIG. 11 is an explanatory diagram schematically showing a configuration of a semiconductor laser module M3 in accordance with a third embodiment of the present invention. As shown in FIG. 11, according to the third embodiment, the semiconductor laser device 2 and the first lens 4 are disposed with tilts at predetermined angles to the axial-line direction so that the first laser beam K1, after traveling through a first lens 4, travels as the normal ray in the axial-line direction of the optical fiber 8. Other than this point, this embodiment is substantially the same as the semiconductor laser module in the first embodiment.

According to the third embodiment, the first laser beam K1 travels as the normal ray in the axial-line direction of the optical fiber 8, and hence there is no necessity of providing the prism 5 between the half-wave plate 6 and the first lens 4, thereby making it possible to simplify the configuration. Further, only one side of the PBC 7 may be polished, and hence the polishing can be more simplified than in the second embodiment.

Moreover, the length of the semiconductor laser module M3 in the optical-axis direction can be reduced, making the optical output less susceptible to the warp of the package that arises in the high-temperature environment.

Note that the half-wave plate 6 and the PBC 7, which are fixed to the same holder member 14, may be structured as a polarization synthesizing module in order to facilitate the angular adjustment about the central axis also in the third embodiment.

Each of the semiconductor laser modules M1 to M3 in the first through third embodiments discussed above is capable of emitting the laser beams with high output, small degree of polarization and stabilized wavelength, and can be therefore used as the pumping light source for the erbium-doped optical amplifier or the Raman amplifier.

(Fourth Embodiment)

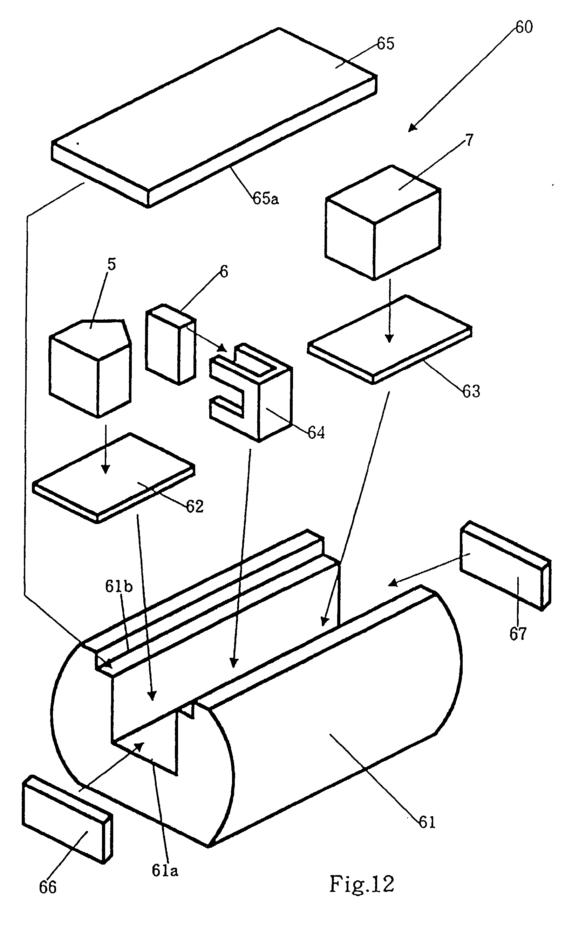

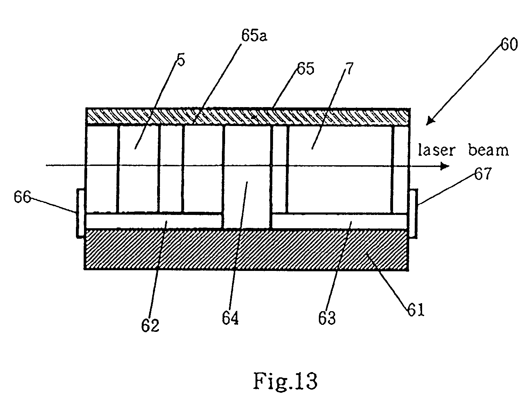

FIG. 12 is a fragmentary perspective view showing a polarization synthesizing module 60 in accordance with a fourth embodiment of the present invention, used for a semiconductor laser module in the present invention, which depicts another example of the polarization synthesizing module 59 shown in FIG. 4. FIG 13 is a side sectional view showing the polarization synthesizing module 60 shown in FIG 12. Note that, the same members as those in the polarization synthesizing module 59 are marked with the same symbols, and their repetitive explanations are omitted.

As shown in FIGS. 12 and 13, the polarization synthesizing module 60 in the fourth embodiment includes a holder member 61 formed with a groove 61a (an accommodation space) extending in the longitudinal direction, first and second adjustment sheets 62, 63 so disposed as to be fitted into the groove 61a of the holder member 61, the prism 5 disposed on the first adjustment sheet 62, the PBC 7 disposed on the second adjustment sheet 63, a half-wave plate holder 64 so disposed as to be fitted into the groove 61a of the holder member 61, the half-wave plate 6 held by the half-wave plate holder 64, and a plate-like top cover 65 fixedly inset in a stepped portion 61b formed on an aperture side of the groove 61a of the holder member 61.

The holder member 61, the half-wave plate holder 64 and the top cover 65 are made of a material (e.g., Fe-Ni-Co alloy (Kovar)) that can be YAG-laser-welded.

An upper portion of the half-wave plate 6 is metalized, and an upper portion of the half-wave plate holder 64 is gold-plated. The upper portion of the half-wave plate 6 is fixed by soldering to the upper portion of the half-wave plate holder 64.

The first and second adjustment sheets 62, 63 are formed of a material deformable enough to facilitate positioning of the prism 5 and the PBC 7 as well. The first and second adjustment sheets 62, 63 may be composed of a flexible member such as a soft metal (In, and so on) or a solder sheet (Sn-Pb, and so forth), or of a resilient member such as a resin.

The polarization synthesizing module 60 is also fitted with first and second stoppers 66, 67 fixed by the YAG laser welding to both side edges of the groove 61a of the holder member 61. As shown in FIG. 13, the first stopper 66 and the half-wave plate holder 64 hold the first adjustment sheet 62 sandwiched in therebetween and thus function as a slide stopper for the first adjustment sheet 62. Further, the second stopper 67 and the half-wave plate holder 64 hold the second adjustment sheet 63 sandwiched in therebetween and thus function as a slide stopper against the second adjustment sheet 63.

Note that the first and second stoppers 66, 67 may be formed beforehand integrally with the holder member 61.

Further, note that the first and second stoppers 66, 67 may be formed of transparent materials such as glass, resin. And the first and second stoppers 66, 67 may be lens, prism, PBC 7, or half wave plate.

Next, a method of assembling the polarization synthesizing module 60 in the fourth embodiment will be explained. At first, the first and second stoppers 66, 67 are fixed by YAG laser welding to both of the side edges of the groove 61a of the holder member 61.

Subsequently, the half-wave plate 6 is secured by soldering to the half-wave plate holder 64.

Then, the half-wave plate holder 64 holding the half-wave plate 6 is fixed by YAG laser welding to the groove 61 a of the holder member 61. On this occasion, the half-wave plate holder 64 is positioned so that the first and second adjustment sheets 62, 63 are respectively fitted in between the first and second stoppers 62, 63 and the half-wave plate holder 64.

Next, the first adjustment sheet 62 is so disposed as to be fitted into the groove 61a of the holder member 61 between the first stopper 66 and the half-wave plate holder 64. Further, the second adjustment sheet 63 is so disposed as to be fitted into the groove 61a of the holder member 61 between the second stopper 67 and the half-wave plate holder 64.

Subsequently, the prism 5 is placed on the first adjustment sheet 62, and the PBC 7 is placed on the second adjustment sheet 63.

Then, the top cover 65 is set in the stepped portion 61b formed on the aperture side of the groove 61a of the holder member 61. The surfaces of the prism 5 and the PBC 7 are brought into contact with and pressed against an undersurface 65a of the top cover 65. The first and second adjustment sheets 62, 63 are thereby deformed, and the prism 5 and the PBC 7 are positioned in desired positions.

Finally, the top cover 65 is fixed by YAG laser welding to the holder member 61.

In this polarization synthesizing module 60, the top surfaces of the prism 5 and the PBC 7 are brought into contact with and pressed against the undersurface 65a of the top cover 65 and positioned with the aid of the deformations of the first and second adjustment sheets 62, 63. The undersurface 65a of the top cover 65 is formed flat with a higher working precision than the surface of the groove 61a. Accordingly, the light incident surfaces of the prism 5 and of the PBC 7, the top surface of which have been brought into contact with the undersurface 65a of the top cover 65, are positioned precisely perpendicular with respect to the undersurface 65a of the top cover 65, whereby a rotational direction θ about the optical axis can be positioned with high accuracy.

Considering from this point, it is feasible that the working precision of the undersurface 65a of the top cover 65 where the topsurface of the prism 5 and PBC are brought into contact, may fulfil at least one of the conditions below of the planar roughness;

maximum height, Rmax =≤ 10 µm,
center-line-average-roughness, Ra =≤ 5 µm,
average roughness measured at 10 points, Ra =≤ 10 µm.

Note that the first and second adjustment sheets 62, 63 can be integrated to one sheet.

Further, note that the prism 5 and the PBC 7 may be gold-plated and fixed by soldering directly to the groove 61a of the holder member 61. In this case, the first and second adjustment sheets 62, 63 are not required, however, it is preferable that the working surface of the groove 61a be formed accurately.

(Fifth Embodiment)

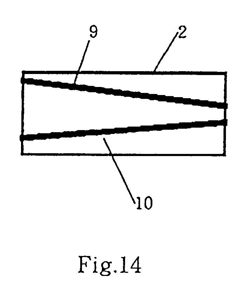

The first and second stripes 9, 10 of the semiconductor laser device 2 described above are formed to extend in parallel to each other in the longitudinal direction. The first and second stripes 9, 10 may, however, be formed to be inclined to each other as shown in FIG. 14. Referring to FIG 14, the laser beams are emitted toward the right side, and the space between the stripes 9 and 10 becomes narrower as it gets closer to the right side edge. In this case, the two first and second laser beams K1, K2 emitted from the two stripes 9, 10 intersect each other at a comparatively short distance away from the semiconductor laser device 2 and thereby decreases a propagation distance L (see FIG2) which is needed for the first and second laser beams K1 and K2 that have traveled though the first lens 4 to split enough for a half wave plate 6 to be able to be inserted only on the beam path of K1 (namely, for a distance D' in FIG2 to take a sufficiently large value), and hence the length of the semiconductor laser module M1 in the optical-axis direction can be reduced.

Note that the propagation distance L can be likewise reduced even when emitting the laser beams in the leftward direction.

(Sixth Embodiment)

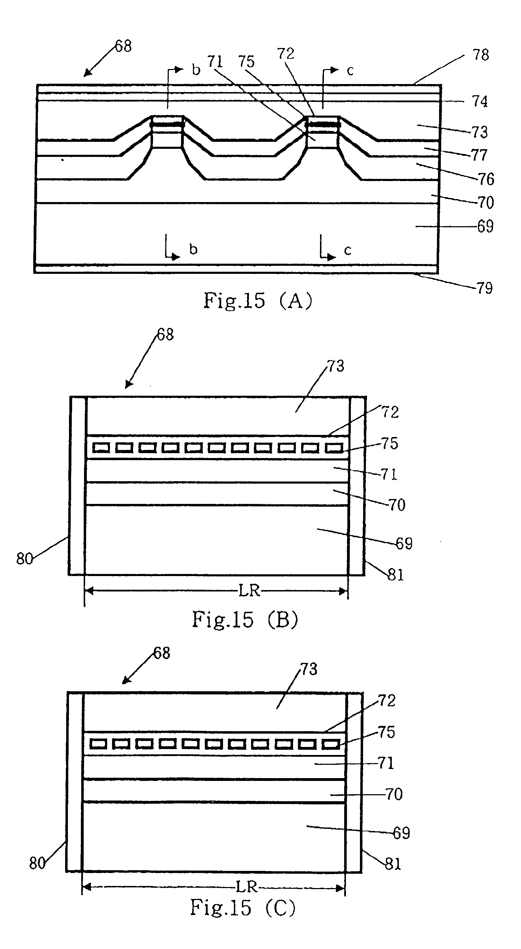

FIGS. 15(A) to 15(C) show a semiconductor laser device 68 in accordance with a sixth embodiment used for the semiconductor laser module in accordance with the embodiments of the present invention and having a different configuration from the semiconductor laser device 2 shown in FIGS. 8(A) to 8(C). FIGS. 15(B) and 15(C) are sectional views taken along the line b-b and the line c-c in FIG. 15(A), respectively.

As shown in FIGS. 15(A) through 15(C), the semiconductor laser device 68 in the sixth embodiment has a structure in which an n-InP buffer layer 70 serving both as a buffer layer and a lower clad layer as well, an active layer 71 comprising a GRIN-SCH-MQW (Graded Index -Separate Confinement Heterostructure multi quantum well), a p-InP clad layer 72, a p-InP buried layer 73 and an GaInAsP cap layer 74, are laminated sequentially on a surface (100) of an n-InP substrate 69.

Within each of the p-InP upper clad layer 72 of the two stripes, p-InGaAs diffraction gratings 75 each having a thickness on the order of 20 nm are formed periodically at a pitch of approximately 230 nm. The diffraction gratings 75 serve to select a center wavelength of the laser beams to a predetermined wavelength, e.g. in the 1480nm band. Upper portions of the p-InP upper clad layer 72 containing the diffraction grating 75, the GRIN-SCH-MQW active layer 71 and the n-InP buffer layer 70, are worked in a mesa stripe. Both sides of the mesa strip are embedded in a p-InP layer 76 and an n-InP layer 77 that are formed as current blocking layers. Further, a p-type electrode 78 is formed on an upper surface of the GaInAsP cap layer 74, and an n-type electrode 79 is formed on an undersurface of the n-InP substrate 69.

A first reflection layer 80 having a reflectance as high as 80% or greater is formed on one edge surface of the semiconductor laser device 68 in the longitudinal direction. A second reflection layer 81 having a reflectance as low as 5% or less is formed on the other edge surface thereof. The beams generated within the GRIN-SCH-MQW active layer 71 of an optical resonator formed between the first and second reflection layers 80, 81, are reflected at the first reflection layer 80 and exit as laser beams via the second reflection layer 81.

The semiconductor laser device 68, if used as a pumping light source for, e.g., the Raman amplifier, has its oscillation wavelength $\lambda_0$ in the range of 1300 to 1550 nm and a cavity length $L_R$ set from 800µm to 3200µm.

Note that, a mode spacing $\Delta\lambda$ of the longitudinal modes generated by the resonator of the semiconductor laser device is generally expressed by the following formula.

Namely;

$$\Delta\lambda = \lambda_0^2 / (2 \cdot n \cdot L_R)$$

Herein, if the oscillation wavelength $\lambda_0$ is set to 1480 $\mu$m and an equivalent refractive index $\underline{n}$ is set to 3.5, the longitudinal mode spacing $\Delta\lambda$ is approximately 0.39 nm for the cavity length $\underline{L}_R$ of 800$\mu$m and approximately 0.1nm for the cavity length of 3200$\mu$m. That is, as the cavity length is set larger, the longitudinal mode spacing $\Delta\lambda$ becomes narrower, which means generally that the selection condition for single longitudinal mode oscillation gets strict as the cavity length is increased.

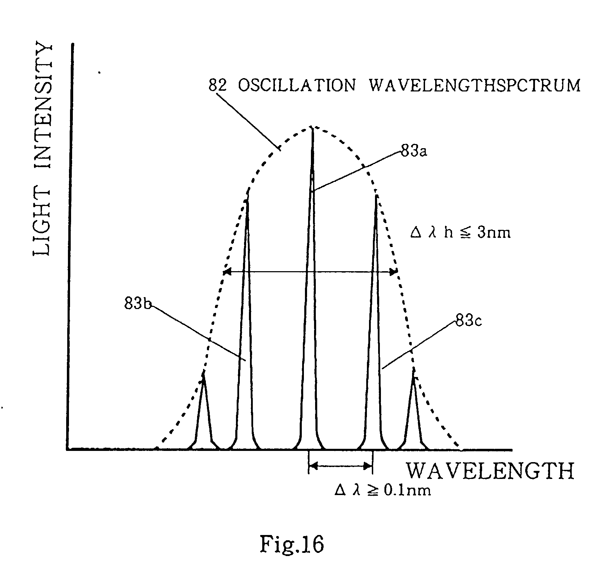

The diffraction grating 75 selects the longitudinal mode with a Bragg wavelength thereof. A wavelength selecting characteristic of this diffraction grating 75 is given as an oscillation spectrum 82 shown in FIG. 16. As shown in FIG. 16, a contrivance in accordance with the sixth embodiment is that a plurality of longitudinal modes are oscillating within the FWHM $\Delta\lambda_h$ of the oscillation spectrum of the semiconductor laser device with the diffraction grating 75. Note that the conventional semiconductor laser with a wavelength selective element such as DFB aimed to oscillate in a single longitudinal mode and therefore the cavity length of 800$\mu$m or larger had not been routinely adopted by those skilled in the art because of its narrower longitudinal mode spacing and lower mode selectivity. The semiconductor laser device 68 in the sixth embodiment, however, with the cavity length $L_R$ positively set to 800$\mu$m or larger, emits the laser beams with a plurality of oscillation longitudinal modes contained within the FWHM $\Delta\lambda_h$ of the oscillation spectrum. Referring to FIG 16, the FWHM $\Delta\lambda_h$ of the oscillation spectrum contains three oscillation longitudinal modes 83a to 83c.

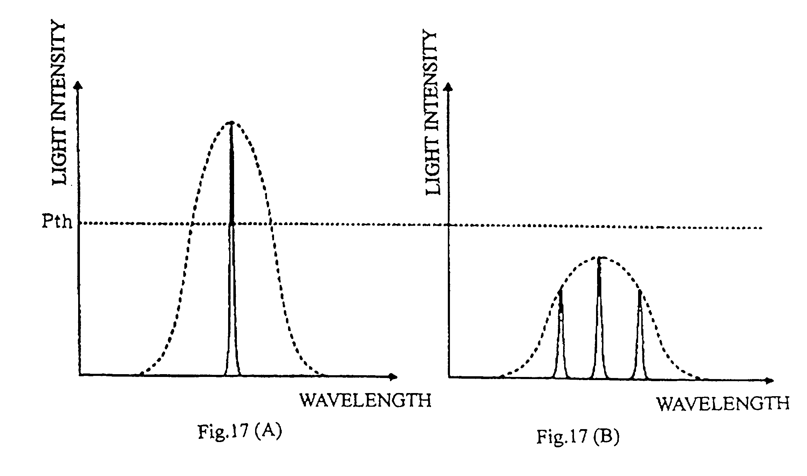

Using the laser beams oscillating in a plurality of longitudinal modes enables to obtain a laser output with the peak intensity of each longitudinal mode more restrained than using the laser beams oscillating in a single longitudinal mode that emit the same intensity of the laser light in total. For example, the semiconductor laser device 68 exemplified in the sixth embodiment has a mode profile as shown in FIG 17(B) and is capable of obtaining a high laser output with a low peak intensity of each longitudinal mode. By contrast, FIG 17 (A) shows a mode profile of the single longitudinal mode oscillations having a higher peak intensity in the case of obtaining the same laser output in total.

The oscillation in a plurality of longitudinal modes is preferred especially in case where the semiconductor laser device is used as a high-powered pumping light source for Raman amplifier, since the semiconductor laser device can operate at high output without the intensity of each of the longitudinal modes exceeding the threshold Pth above which the stimulated Brillouin scattering can occur, as shown in FIG.17(B), which may be a cause of noise in Raman amplification. Consequently, a high Raman gain can be acquired by using the semiconductor laser device as a pumping light source without no significant increase in noise.

Further, as shown in FIG. 16, the wavelength spacing (mode spacing) $\Delta\lambda$ between the oscillation longitudinal modes 83a to 83c is preferably set to 0.1 nm or larger, because such a longitudinal mode spacing is effective for mitigating the stimulated Brillouin scattering that may occur for high-powered lasers. Note that the cavity length $L_R$ of 3200$\mu$m or shorter gives $\Delta\lambda$ of 0.1nm or larger of a semiconductor laser device oscillating at 1480nm.

Furthermore, in Raman amplification, the Raman gain is dependent on the polarization of the signal light (i. e. the amplification takes place when the polarization plane of the signal light and of the pumping light coincide). Therefore, the pumping light is preferred to be depolarized in order to obviate the problem of gain fluctuation associated with the random nature of the polarization of the signal light.

The semiconductor laser module according to the first through sixth embodiments of the present invention emits a polarization-multiplexed laser light with lower DOP than laser light from a single stripe, and therefore is suitable for use as a pumping light source in Raman amplifiers. In case, however, that DOP is not sufficiently reduced, a further measure for depolarization might be employed.

For that purpose, the depolarization can be done using a length of polarization maintaining fiber through which the pumping light from a semiconductor laser device propagates. And the more the number of longitudinal modes is, the shorter a necessary length of the polarization maintaining fiber becomes, because the coherent length of the laser light decreases as the number of longitudinal modes increases.

In this regard, the number of longitudinal modes contained within the FWHM $\Delta\lambda_h$ of the oscillation spectrum is preferably three or more. Particularly when there are four or five oscillation longitudinal modes, the necessary length of the polarization maintaining fiber abruptly decreases. Accordingly, the length of the polarization maintaining fiber used for depolarizing can be reduced by including three or more, and more preferably four or more longitudinal modes within the FWHM $\Delta\lambda_h$ of the oscillation spectrum, thereby simplifying the amplifier and reducing the cost thereof.

Herein, if the oscillation spectral width (the FWHM of the oscillation spectrum) is too large, a multiplexing loss by a wavelength synthesizing coupler increases, and a fluctuation of longitudinal modes within the spectral width might create noise or fluctuation of gain. Therefore, the FWHM $\Delta\lambda_h$ of the oscillation spectrum 82 is preferably set to 3 nm or less and still preferably to 2 nm or less.

Moreover, in the semiconductor laser module with the fiber Bragg grating (FBG), a resonance between the FBG and rear edge surface 2b of the semiconductor laser device, creates noise peaks that appear periodically on the frequency axis of the RIN (relative intensity noise) profile of the pumping light, adding noise to amplified signal in Raman amplifiers.

By contrast, the semiconductor laser module using the semiconductor laser device 68 with a diffraction grating integrated in the stripes emits a wavelength-stabilized laser light with no such noise peak, and therefore is suitable for use as a pumping light source of Raman amplifier.

Further, the semiconductor laser module using the FBG includes the mechanical coupling within the resonator (i.e. YAG welding spots connecting a flange 1a and a ferrule 23 holding an optical fiber 8 with FBG), and consequently there arises a case in which the oscillation characteristic of the laser changes due to the vibrations or the change in temperature. By contrast, the semiconductor laser device 68 in the sixth embodiment requires no mechanical coupling to form a resonator, and is free from change in the laser oscillation characteristic due to the mechanical vibrations or the change in temperature, and is capable of obtaining the stable optical output.

According to the sixth embodiment, since the semiconductor laser device 68 emits laser beams with wavelength between 1300 to 1500nm selected by the diffraction gratings 75, and since it is equipped with a cavity of 800 to 3200$\mu$m in length $L_R$, it emits laser beams with a plurality of longitudinal modes, preferably four or more longitudinal modes, oscillated within the FWHM $\Delta\lambda_h$ of the oscillation spectrum. As a result, the stable and high Raman gain can be obtained without the occurrence of the stimulated Brillouin scattering when used as the pumping light source for the Raman amplifier.

Furthermore, since the semiconductor laser device 68 is equipped with diffraction gratings 75 integrated in the stripes, it is free from instability associated with the vibration or the change in temperature that otherwise might have affected the coupling to the optical fiber with FBG which was external to the semiconductor laser device.


(Seventh Embodiment)

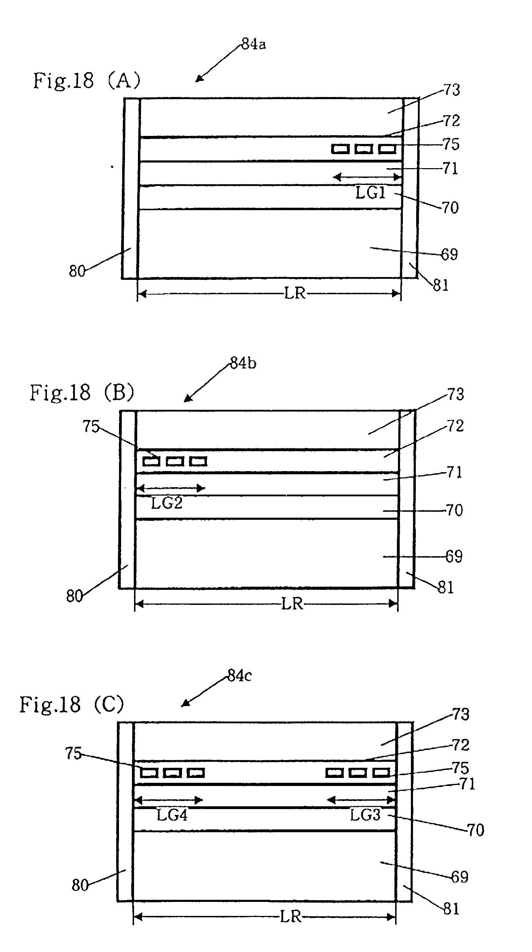

FIGS. 18(A) to 18(C) are vertical sectional views each showing a configuration of the semiconductor laser device in the longitudinal direction according to a seventh embodiment.

In the sixth embodiment discussed above, there are provided a plurality of longitudinal modes within FWHM $\Delta\lambda_h$ of the oscillation spectrum 82 by increasing the cavity length $L_R$. In contrast with this contrivance, according to the seventh embodiment, the FWHM $\Delta\lambda_h$ of the oscillation spectrum 82 is changed by varying a grating length LG of the diffraction grating 75 or a coupling coefficient, whereby the number of longitudinal modes within FWHM $\Delta\lambda_h$ is increased.

As shown in FIG 18(A), a semiconductor laser device 84a is different from the semiconductor laser device 68 in the sixth embodiment in the layout of the diffraction gratings 75 and in the reflectance of the second reflection layer 81. The configurations of other components are substantially the same as those of the semiconductor laser device 68, and the same components are marked with the same reference numerals, of which the repetitive explanations are omitted.

The diffraction gratings 75 are formed over a predetermined length LG1 ,which is shorter than the entire cavity length $L_R$, as opposed to the case shown in FIG.15(B), extending from the second reflection layer 81 having a reflectance as low as 2% or less, preferably 1% or less, more preferably 0.2% or less toward the first reflection layer 80 having a reflectance as high as 80% or greater, but not formed in the p-InP clad layer 72 out of the predetermined length LG1.

Further, FIG. 18(B) is a vertical sectional view showing in the longitudinal direction a configuration of a semiconductor laser device 84b defined as a modified example of the seventh embodiment. This semiconductor laser device 84b has the diffraction gratings 75 provided on the side of the first reflection layer 80, in which the reflectance of the first reflection layer 80 is set to be low. Namely, the diffraction gratings 75 are provided over a predetermined length LG2, which is shorter than the entire cavity length $L_R$, as opposed to the case shown in FIG.15(B), extending from the first reflection layer 80 having a reflectance as low as 0.1 to 2% toward the second reflection layer 81 having a reflectance as low as 1 to 5%, but are not formed in the upper p-InP clad layer 72 out of the predetermined length LG2.

Moreover, FIG. 18(C) is a vertical sectional view showing in the longitudinal direction a configuration of a semiconductor laser device 84c defined as another modified example of the seventh embodiment. This semiconductor laser device 84c simultaneously adopts the layouts of the diffraction gratings 75 shown in FIG. 18(A) and of the diffraction gratings 75 shown in FIG. 18(B).

Namely, the semiconductor laser device 84c has the diffraction gratings 75 formed over a predetermined length LG3, which is shorter than the entire cavity length $L_R$, as opposed to the case shown in FIG.15(B), extending from the second reflection layer 81 having a reflectance as low as 2% or less toward the first reflection layer 80 having a reflectance as low as 2% or less, and the diffraction gratings 75 formed over a predetermined length LG4, which is shorter than the entire cavity length $L_R$, as opposed to the case shown in fig.15(B), extending from the first reflection layer 80 toward the second reflection layer 81.

The FWHM $\Delta\lambda_h$ of the oscillation spectrum 82 shown in FIG 16 can be varied by changing the predetermined lengths of the diffraction gratings 75 shown in FIG 18 while the mode spacing $\Delta\lambda$ of the oscillation longitudinal modes is kept constant.

That is, it is effective to reduce the length of the diffraction gratings 75 for increasing the FWHM $\Delta\lambda_h$ of the oscillation spectrum 82. Hence, as shown in the seventh embodiment, the diffraction gratings 75 are not formed over the entire length of the resonator (GRIN-SCH-MQW active layer 71) but are formed on a segment of this cavity length.

In this case, a laser oscillation characteristics might not suffice unless the reciprocating light meets the phase matching condition defined by the resonator cavity, the deviation from the phase matching condition existing depending on the positions of the diffraction gratings 75 within the resonator. Hence, as shown in FIG. 18(A), if the diffraction gratings 75 are formed extending from the second reflection layer 81 up to a point halfway along the resonator toward the first reflection layer 80, the second reflection layer 81 preferably has the reflectance of as low as 2% or less, and the first reflecting layer 80 preferably has the reflectance of as high as 80% or greater. Further, as shown in FIG.18 (B), if the diffraction gratings 75 are formed extending from the first reflection layer 80 up to a point halfway along the resonator toward the second reflection layer 81, the first reflection layer 80 preferably has the reflectance of as low as 2% or less, and the second reflecting layer 81 preferably has the reflectance of as low as 1 to 5%. Moreover, as shown in FIG. 18(C), if the diffraction gratings 75 are formed on both sides of the second and first reflection layers 81 and 80, both of the second and first reflection layers 81, 80 preferably have low reflectances of 2% or less.

Further, as shown in FIG 18(A), when the diffraction gratings 75 are formed on the side of the second reflection layer 81, it is preferable that the reflectance of the diffraction grating 75 itself be set comparatively low. As shown in FIG. 18(B), when the diffraction gratings 75 are formed on the side of the first reflection layer 80, it is preferable that the reflectance of the diffraction grating 75 itself be set comparatively high. Moreover, as shown in FIG. 18(C), when the diffraction gratings 75 are formed on both sides of the first and second reflection layers 80, 81, the reflectance of the diffraction grating 75 itself provided on one side is preferably set comparatively low, and the reflectance of the diffraction grating 75 itself formed on the other side is preferably set comparatively high. With the settings described above, the influence of the Fabry Perot resonator formed by the first and second reflection layers 80, 81 can be reduced and the wavelength selection by the diffraction gratings 75 is effected.

To be more specific, the semiconductor laser device shown in FIG. 18(A) may be 1300µm in the cavity length $L_R$, 50µm in the length (LG1) of the diffraction gratings 75, and 0.125 in the product $K*L_G$ of the coupling coefficient K and the length of grating $L_G$. The diffraction gratings 75 described above can generate approximately 2nm of the FWHM $\Delta\lambda_h$ of the oscillation spectrum 82 which contains three to eight oscillation longitudinal modes.

Further, referring to FIGS. 18(A) through 18(C), the diffraction gratings 75 are provided on either side of the second reflection layer 81 or the first reflection layer 80, or on the both sides of the second and first reflection layers 81, 80. The diffraction gratings 75 may not be limited to the above layouts, but may be formed on any segment of the cavity length along the GRIN-SCH-MQW active layer 71.

According to the seventh embodiment, the length of the diffraction gratings 75 is set segmental to the cavity length $L_R$, and the grating length LG and the coupling coefficient $KL_G$ of the diffraction gratings 75 are properly varied, thereby obtaining the desired FWHM$\Delta\lambda_h$ of the oscillation spectrum 82. Then, the laser beams having a plurality of oscillation longitudinal modes within this FWHM $\Delta\lambda_h$ can be obtained, and the semiconductor laser device exhibiting the same advantage as the sixth embodiment can be realized.

(Eighth Embodiment)

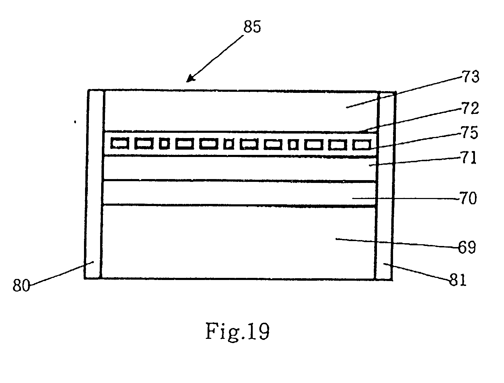

FIG. 19 is a vertical sectional view showing in the longitudinal direction a configuration of the semiconductor laser device in accordance with an eighth embodiment of the present invention.

The grating period of the diffraction gratings 75 is fixed in the sixth and seventh embodiments discussed above. In this eighth embodiment, however, the diffraction grating is chirped to have a periodical change in the grating period , thereby causing a fluctuation in the wavelength selection characteristic of the diffraction gratings 75, which leads to the broadening of the FWHM $\Delta\lambda_h$ of the oscillation spectrum 82, and increase in the number of oscillating longitudinal modes within the FWHM $\Delta\lambda_h$.

As shown in FIG. 19, the semiconductor laser device 85 has a chirped gratings 75 of which the grating period is periodically changed. The configurations of other components are the same as those of the semiconductor laser device 68 in the sixth embodiment, and the same components are marked with the same symbols, of which the repetitive explanations are omitted.

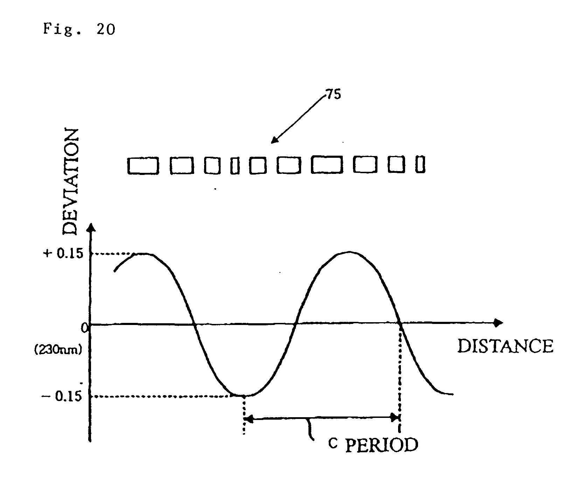

FIG 20 is a graph showing the periodic change in the grating period of the diffraction gratings 75. As shown in FIG 20, the diffraction gratings 75 have an average period of 230 nm with a periodic fluctuation (deviation) of the magnitude of ±0.15 nm that repeats with a period C. This periodic fluctuation generates a FWHM of approximately 2 nm for the reflection band of the diffraction grating 75, and about three to six oscillation longitudinal modes can be thereby present within the FWHM $\Delta\lambda_h$ of the oscillation spectrum 82.

In the eighth embodiment discussed above, the chirped gratings are formed over an entire cavity length $L_R$. The chirped diffraction gratings 75 may not be limited to the above layouts, but may be disposed to a segment of the cavity length $L_R$. Namely, the chirped gratings exemplified in the eighth embodiment discussed above may be applied to the seventh embodiment.

Further, the eighth embodiment involves the use of the chirped gratings with the fixed period C of the fluctuation. The period of fluctuation is not, however, limited to this fixed period C but may be changed at random between a period Λ1 (230 nm +0.15 nm) and a period Λ2 (230 nm - 0.15 nm).

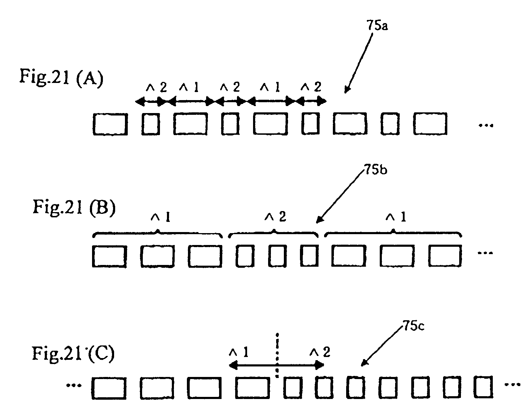

Moreover, as shown in FIG. 21(A), the diffraction grating 75a may be equipped with pairs of period Λ1 and Λ2, each period alternating one by one to give fluctuations in its period. Further, as shown in FIG. 21(B), the diffraction gratings 75b may be equiped with pairs of a group of a plurality of period Λ1 and a group of a plurality of period Λ2, each group alternating one by one to give fluctuations in its period. Still further, as shown in FIG. 21(C), the diffraction grating 75c may be constituted of a plurality of period Λ1 and a plurality of period Λ2, each period occurring consecutively to give fluctuation in its period. Moreover, the diffraction gratings may be laid out such that a plurality of discrete values interpolate between Λ1 and Λ2.

In the eighth embodiment, the diffraction gratings 75 formed in the semiconductor laser device are chirped so that it gives the period fluctuation of the magnitude of ±0.05 to 0.2 nm around the average. The FWHM of the reflection band of the diffraction grating 75 and the resulting FWHM $\Delta\lambda_h$ of the oscillation spectrum is thereby set to a desired value so that the laser beams with a plurality of oscillation longitudinal modes contained within the FWHM $\Delta\lambda_h$ are outputted. It is therefore possible to realize the semiconductor laser device having the same advantage as the sixth or seventh embodiment.

(Ninth Embodiment)

According to the semiconductor laser devices in the sixth through eighth embodiments, the wavelengths selected by the diffraction gratings 75 formed in the two stripes are substantially the same. By contrast, according to the semiconductor laser device in accordance with a ninth embodiment of the present invention, the wavelengths selected by the diffraction gratings 75 formed in the two stripes are different.

If the wavelengths selected by the diffraction gratings 75 formed in the two stripes are slightly different (by 0.1 nm or larger but less than 3 nm, for example, approximately 0.5 nm), the oscillation spectrums from the two stripes overlap to contain a larger number of longitudinal modes within the FWHM, which is suitable for use in Raman amplification in terms of decreasing DOP.

Furthermore, the two stripes can be designed to have diffraction gratings with different wavelengths, each having a wavelength different from the other by on the order of several nanometers to several tens of nanometers (e. g.3nm or larger). The laser beams emitted from the two stripes of the single semiconductor laser device are wavelength-multiplexed by use of a built-in wavelength synthesizing element provided in a package 1, and thus eliminating the need for an external wavelength-synthesizing couplers that are conventionally used for multiplexing laser lights from a plurality of discrete semiconductor laser modules, leading to downsizing of amplifiers.

In this case, the optical output often needs to be controlled by the respective wavelengths thereof. For this purpose, a separation trench 38 is formed between the two stripes, as shown in FIG 8(C), and the surface of which is covered with an insulation layer 39, whereby the two stripes are electrically separated and can be driven independently.

In the sixth through ninth embodiments, the wavelengths of the laser beams outputted from the semiconductor laser module can be arbitrarily set by forming the two stripes with an arbitrary combination of the diffraction gratings 75.

Note that the half-wavelength plate 6 may not be used if the laser beams emitted from the two stripes, each emitting a laser beam of different wavelength, are wavelength-synthesized without a birefringence material such as rutile, namely if the laser beams are wavelength-synthesized by use of, for example, a prism.

(Tenth Embodiment)

If a polarization-maintaining fiber with FBG is used to receive the two fluxes of laser beams from the double-stripe type semiconductor laser module as exemplified in the first through fifth embodiments, the polarization-maintaining fiber is normally aligned so that the polarizing directions of the two fluxes of laser beams are coincident with polarization-maintaining axes of the polarization-maintaining fiber.

By contrast, the tenth embodiment uses the semiconductor laser device formed with the two stripes containing the diffraction gratings 75 as exemplified in each of the sixth through ninth embodiments and eliminates the need for FBG, wherein the optical coupling may be attained in such a way that the polarization-maintaining axes of the polarization maintaining fiber deviates by 45 degrees from the polarizing direction of each of the two fluxes of laser beams emitted from the semiconductor laser device. This contrivance enables the polarization maintaining fiber to function as a depolarizer which effectively reduces the DOP.

(Eleventh Embodiment)

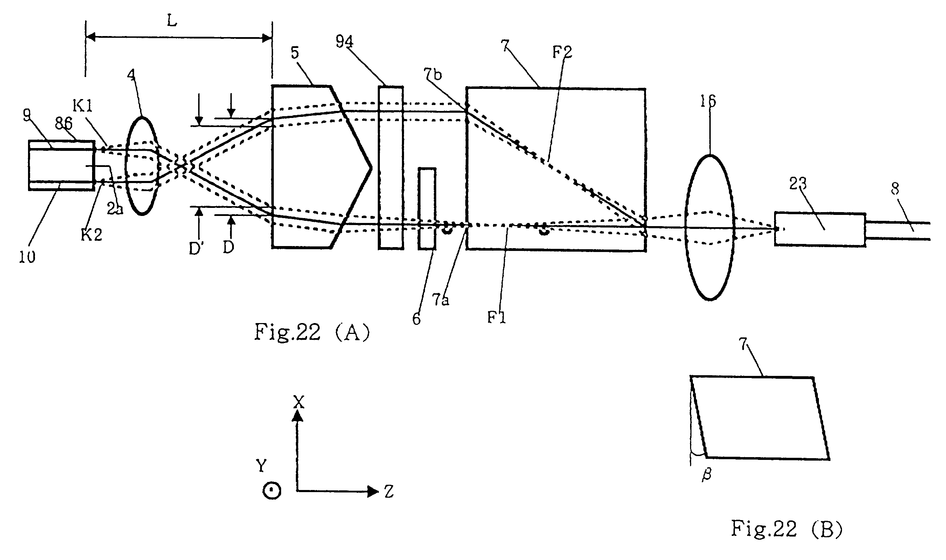

FIG. 22(A) is an explanatory diagram schematically showing a configuration of the semiconductor laser module in accordance with an eleventh embodiment of the present invention.

As shown in FIG. 22(A), the eleventh embodiment uses one of the semiconductor laser devices as exemplified in each of the sixth through tenth embodiments (which is representatively denoted by the numeral 86) each provided with the diffraction gratings 75 in the two stripes 9, 10, and thus eliminates the need for_providing an optical fiber 8 with a beam reflection element 15 such as FBG and so on. Further, an optical isolator 94 is disposed between the first lens 4 and the second lens 16 that transmits the first beam K1 and the second laser beam K2 emitted from the semiconductor laser device 86 only toward the optical fiber 8. Other than this point, this embodiment is substantially the same as the semiconductor laser module in the first embodiment. The optical isolator disposed therebetween enables for the semiconductor laser device 86 to be stabilized of its operation by preventing the reflection from being coupled back to the semiconductor laser device 86. Note that the optical isolator 94 is disposed in a position where the first and second laser beams K1, K2 are parallel, e.g., a position between the prism 5 and the half-wavelength plate 6, whereby one single optical isolator 94 can deal both.

Instead of using an optical isolator 94, the PBC 7 may be inclined so that the laser beams K1, K2 are obliquely incident on an incident surface of the PBC 7 in order to prevent the reflection from coupling back to the semiconductor laser device 86. Note that the half-wave plate 6 and the PBC 7 may be fixed to the same holder member 14 to configure the polarization synthesizing module in order to facilitate the angular adjustment.

Further, as shown in FIG. 22(B), an incident surface of the PBC 7 may be given an inclination of angle β(e. g., 4 degrees) in the Z-axis direction for preventing the reflection from coupling back to the semiconductor laser device 86.

(Twelfth Embodiment)

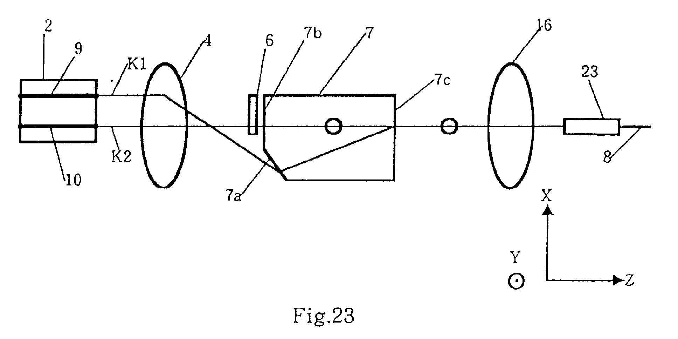

FIGS. 23 is an explanatory diagram schematically showing a configuration of the semiconductor laser module in accordance with a twelfth embodiment of the present invention.

As shown in FIG 23, the twelfth embodiment has such a characteristic configuration that the second laser beams K2 of the first and second laser beams K1, K2 emitted from the semiconductor laser device 2 including the two stripes 9, 10 travels through the central point of the first lens 4 in the axial-line direction of the optical fiber 8.

In the optical synthesizing element 7 (PBC), the input part 7b and the output part 7c for the second laser beam K2 are formed perpendicular to the optical axis of the second laser beam K2, and the input part 7a for the first laser beam K1 is formed with an inclination to these surfaces. Other than this point, this embodiment is substantially the same as the semiconductor laser module in the first embodiment.

According to the twelfth embodiment, since the second laser beam K2 travels through the central point of the first lens 4 in the axial-line direction of the optical fiber 8, and since the first laser beam K1 is deflected by the first lens 4 with a wider divergence from the second laser beam K2, it is possible to eliminate the necessity of providing the prism and to simplify the configuration.

Moreover, since the length of the semiconductor laser module in the optical axial direction can be reduced, the optical output becomes less susceptible to the warp of the package that arises in the high-temperature environment.

Further, since polishing to form the inclined surfaces onto the optical synthesizing element 7 is needed only for the input part 7a, the optical synthesizing element 7 can be obtained by reduced cost.

Note that the half-wavelength plate 6 and the PBC 7 may be fixed to the same holder member 14 to configure the polarization synthesizing module in order to facilitate the angular adjustment about the central axis.

(Thirteenth Embodiment)

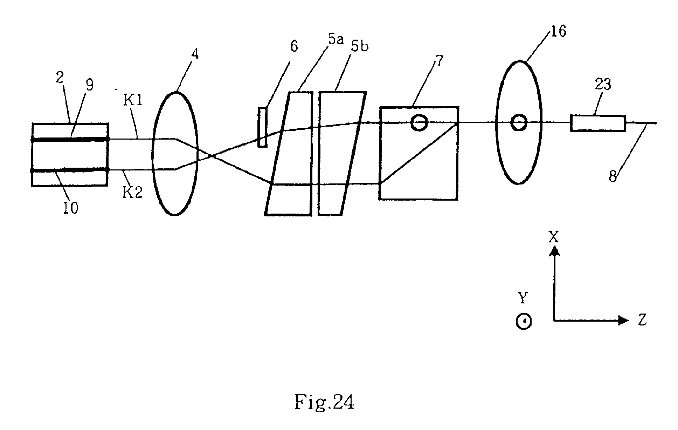

FIG. 24 is an explanatory diagram schematically showing a configuration of the semiconductor laser module in accordance with a thirteenth embodiment of the present invention.

As shown in FIG 24, the thirteenth embodiment has such a characteristic configuration that a plurality (two pieces, for instance, in FIG. 24) of prisms 5a, 5b are disposed in the optical-axis direction. The prisms 5a, 5b have flat input surfaces for inputting the two laser beams K1, K2 and flat output surfaces formed in non-parallel to the input surfaces. Other than this point, this embodiment is substantially the same as the semiconductor laser module in the first embodiment. According to the thirteenth embodiment, the two laser beams K1, K2 can be collimated by the prisms with high accuracy.

Note that in this embodiment, the semiconductor laser device with diffraction gratings 75 each having different wavelength can be employed.

(Fourteenth Embodiment)

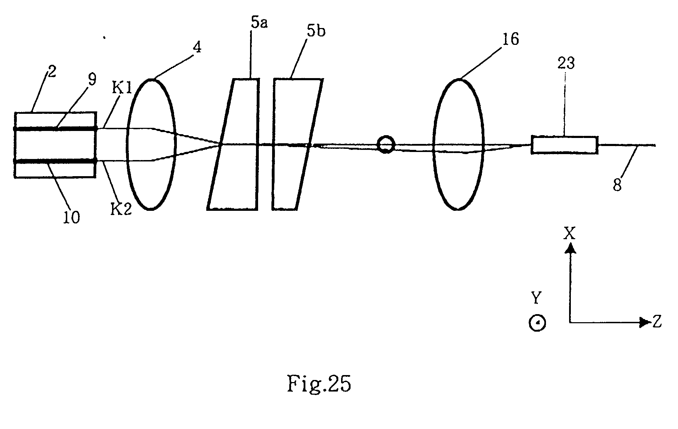

FIG. 25 is an explanatory diagram schematically showing a configuration of the semiconductor laser module in accordance with a fourteenth embodiment of the present invention.

As shown in FIG. 25, the fourteenth embodiment involves the use of the same prisms 5a, 5b as those in the thirteenth embodiment and has such a characteristic that the incident surface of the prism 5a is disposed in a position where the first and second laser beams K1, K2 penetrating the first lens 4 are substantially overlapping with each other. And further, in this embodiment, the semiconductor laser device 2 is equipped with diffraction gratings 75, each stripe having one of different wavelength each other. According to the fourteenth embodiment, the two laser beams K1, K2 penetrating the prisms 5a, 5b and substantially overlapping with each other are incident upon the condenser lens 16, and therefore it is possible to obtain a more simplified configuration. Note that the prisms 5a, 5b are herein defined as wavelength synthesizing elements.

Further, since the length of the semiconductor laser module in the optical axial direction can be reduced, the optical output becomes less susceptible to the warp of the package that arises in the high-temperature environment.

(Fifteenth Embodiment)

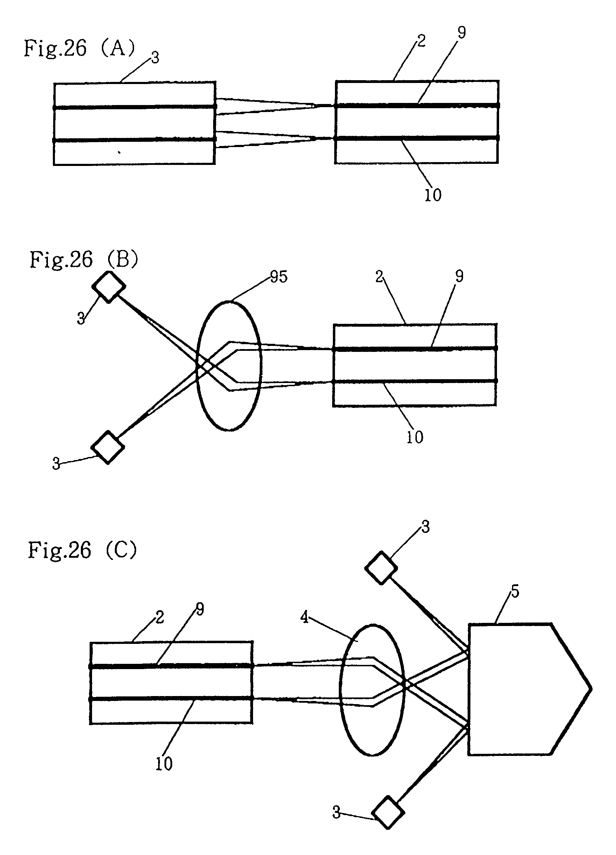

FIGS. 26(A) to 26(C) are explanatory diagrams showing an example of the photo diode (the light receiving element) 3 in accordance with a fifteenth embodiment of the present invention.

The photo diode 3 may be, as shown in FIG. 26(A), a waveguide type light receiving device for receiving the beams emitted from the rear (left side in FIG.26) edge surfaces of the stripes 9, 10 of the semiconductor laser device 2.

Further, a plurality of photo diodes 3 may be, as shown in FIG. 26(B), provided for receiving to monitor the respective beams emitted from the rear edge surfaces of the stripes 9, 10 of the semiconductor laser device 2. In this case, a lens 95 is preferably disposed between the semiconductor laser device 2 and the photo diode 3 for splitting the laser beams emitted from the semiconductor laser device 2 so as to have a divergence therebetween.

Further, the photo diode 3 may receive to monitor the respective beams which are emitted from the front edge surfaces of the stripes 9,10 and reflected by the prism5 as shown in FIG. 26(C).

An APC (auto power control) circuit, for instance, adjust a quantity of the drive current supplied to each of the stripes of the semiconductor laser device 2 based on the result of monitoring by the photo diodes 3, thereby controlling the optical outputs at a constant level.

According to the configuration described above, the APC can be effected on the two stripes independently, and the laser beams K1, K2 can also be kept at an arbitrary light intensity balance.

(Sixteenth Embodiment)

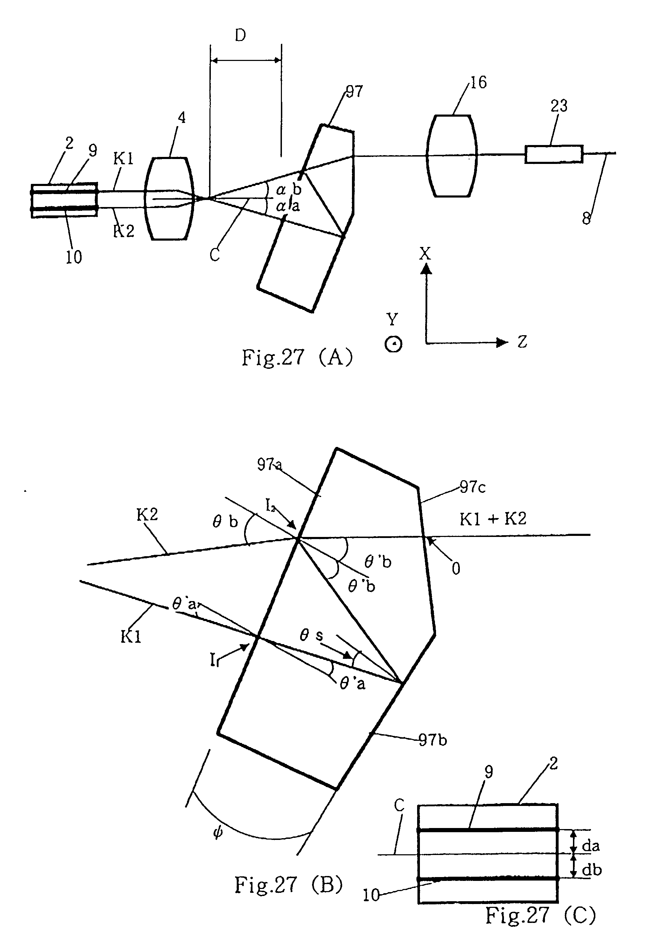

FIGS. 27(A) and 27(B) are explanatory diagrams schematically showing a configuration of the semiconductor laser module in accordance with a sixteenth embodiment of the present invention.

As shown in FIG. 27(A), the semiconductor laser module in the sixteenth embodiment includes the semiconductor laser device 2, having the plurality of stripes 9, 10 (two stripes in an example shown in FIG 27) formed with a space therebetween, for emitting a plurality of laser beams K1, K2 from the front edge surfaces thereof. The semiconductor laser module further includes the first lens 4 for converging a plurality of laser beams emitted from the semiconductor laser device each on a different focal point, a prism 97 serving as a beam synthesizing element for synthesizing the plurality of laser beams traveling through the first lens 4, and the optical fiber 8 for receiving the laser beams emerging from the prism 97 and letting the beams travel outside.

The stripes 9, 10 of the semiconductor laser device 2 include the diffraction gratings 75 described above, each stripe emitting laser beam of different wavelength each other.

The sixteenth embodiment uses, as shown in FIG. 27(B), a wedge-shaped prism 97. The incident surface of this wedge-shaped prism is formed with a wavelength selection filter 97a composed of, e.g., dielectric multi-layer film that reflects or transmits the incident laser beam depending on the wavelength and the incident angle thereof.

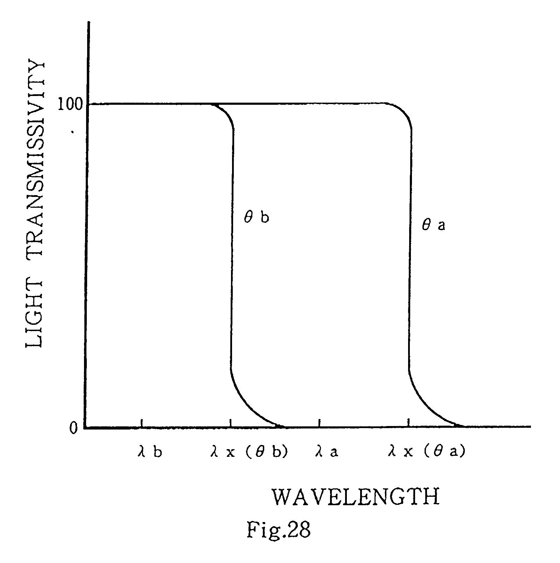

FIG. 28 is a graph showing a beam transmissivity of the wavelength selection filter 97a. As shown in FIG.28, the beam transmissivity depends on an incident angle upon the wavelength selection filter 97a. When the incident angle is $\theta$b, the filter 97a transmits almost 100% of the incident beams of the wavelength$\lambda$x($\theta$b) or less, while reflects almost 100% of the incident beams of the wavelength longer than$\lambda$x($\theta$b). Further, when the incident angle $\theta$a$\square$the filter 97a transmits almost 100% of the incident beams of the wavelength$\lambda$x($\theta$a) or less, while reflects almost 100% of the incident beams of the wavelength longer than$\lambda$x($\theta$a).

Moreover, the exit surface of the wedge-shaped prism 97 is formed with a total reflection layer 97b that reflects the beams irrespective of the wavelengths, and an antireflection layer 97c that prevents the reflection.

In the sixteenth embodiment, the prism 97 is inclined so that the laser beams K1, K2 are incident on the wavelength selection filter 97a at an angle $\theta$a and $\theta$b, respectively, with the wavelengths of the laser beams K1, K2 being set to $\lambda$a and $\lambda$b, respectively.

In this case, the first laser beam K1, incident on the first input part $I_1$ of the wavelength selection filter 97a at the angle $\theta$a, propagates at an angle $\theta$'a through the prism 97 with a refractive index Np. Then, the first laser beam K1 is reflected at an angle $\theta$s ($\theta$a + wedge angle$\Psi$) from the total reflection layer 97b (the reflection part) and reaches the second input part $I_2$ for the second laser beam K2.

The second laser beam K2, incident on the second input part $I_2$ of the wavelength selection filter 97a at the angle θb, propagates at the angle θ'b through the prism 97 with the refractive index Np. Since the first laser beam K1 is reflected at an angle θ'b (2θs + wedge angle Ψ) from the second input part $I_2$ of the wavelength selection filter 97a, the first and second laser beams K1, K2 are synthesized. The synthesized laser beam (K1 + K2) travels through the output part O formed with the antireflection layer 97c.

The optical module in the sixteenth embodiment is designed based on, e.g., the following numerical values and can be thereby embodied.

(1) The oscillation wavelength of each of the stripes of the semiconductor laser device : λa = 1480 nm, λb = 1460 nm;
(2) The beam spot size (radius) at the light-exit surface (front edge surface) of the semiconductor laser device : wLD = 1.7 μm;
(3) The distance between the first stripe 9 and the optical axis C of the first lens 4 : da = - tanαa · f2 = 19.16 μm;
(4) The distance between the second stripe 10 and the optical axis C of the first lens 4 : db = - tanαb · f2 = -19.16μm
(5) The focal length of the first lens 4 : f2 = 720 μm;
(6) The angle made between the optical axis C of the first lens 4 and the first laser beam K1 : αa = (θa - θb)/2 = -1.524°;
(7) The angle made between the optical axis C of the first lens 4 and the second laser beam K2 : αb = (θb -θa)/2 = 1.524°;
(8) The parameter of prism 97 :Ψ(wedge angle) = 1°, Np = 1.5;
(9) The thickness of the prism 97 in the incident position of the first laser beam K1 : t = 1mm;
(10) The angle of incidence and refraction of the laser beams by the prism 97 : θa = 12.050°, θ'a = 8°, θb = 15.098°, θ'b = 10°;
(11) The interval between the incident positions of the first and second laser beams K1, K2 : $\Delta y \doteqdot$ 2(tanθa +Ψ)t$\doteqdot$ 0.462 mm;
(12) The distance alomg the optical axis from the intersecting position of the two beams to the edge surface of the prism 97 : D$\doteqdot$ $\Delta y$/ (θb -θa) = 8.7 mm;
(13) The cut-off wavelengths of the wavelength selection filter 97a : λx(θa) = 1486.5 nm,□λx (θb) = 1470 nm, λx (0) = 1522.6 nm;
(14) The focal length of the second lens 4 : f3 = 2100 μm;
(15) The mode field radius of the optical fiber : wf = 5 μm

Note that the maximum allowable angular tolerance Δθ, which is defined as the width of the intersecting angle θ of the laser beams K1, K2 that have traveled through the first lens 4 at both ends of which the coupling efficiency to the optical fiber decreases by 1dB from maximum, is about 0.013°. For the intersecting angle θ to fall within this range, the respective elements may be manufactured such that the wedge angle of the prism 97 (Ψ) fall within 1 ± 0.003°, the distance between the first stripe 9 or second stripe 10 and the optical axis C of the first lens 4 (da, -db) within 19.16 ± 0.03 μm, and the focal length of the first lens 4 (f2) within 720± 0.7 μm. With such parameters met, the_coupling efficiency of each of the stripes 9, 10 to the optical fiber 8 can be set to 80% or greater.

(Seventeenth Embodiment)

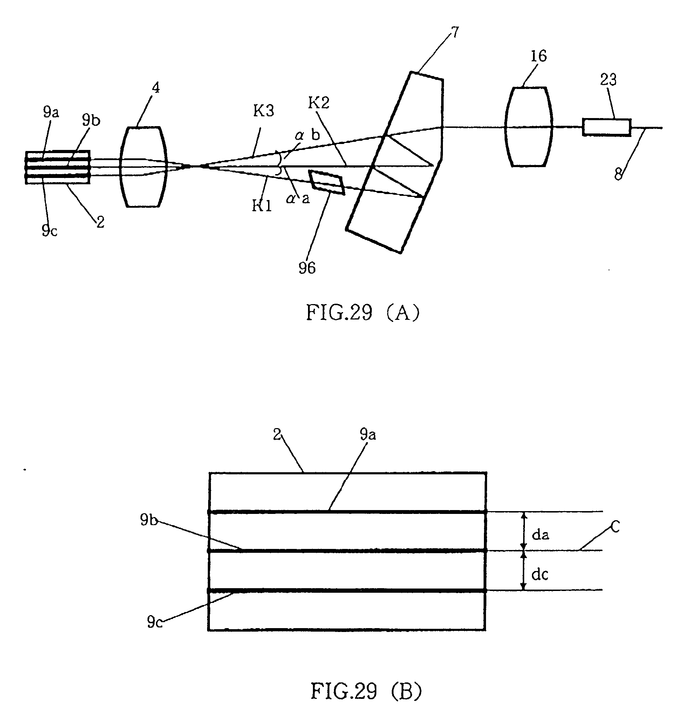

FIGS. 29(A) and 29(B) are explanatory diagrams schematically showing a configuration of the semiconductor laser module in accordance with a seventeenth embodiment of the present invention.

As shown in FIG. 29(A), the semiconductor laser module in the seventeenth embodiment includes the semiconductor laser device 2, having the plurality of stripes 9a, 9b, 9c (three stripes in FIG. 29, for instance) formed with a space therebetween, for emitting a plurality of laser beams K1, K2, K3 from the front edge surfaces of the stripes 9a, 9b, 9c. The semiconductor laser module further includes the first lens 4 for converging the plurality of laser beams emitted from the semiconductor laser device each on a different focal point, the prism 97 for synthesizing the plurality of laser beams traveling through the first lens 4, and the optical fiber 8 for receiving the laser beams emerging from the prism 97 and letting the beams travel outside.

The stripes 9a, 9b, 9c of the semiconductor laser device 2 include the diffraction gratings 75 described above, each stripe emitting laser beam of different wavelength from the others.

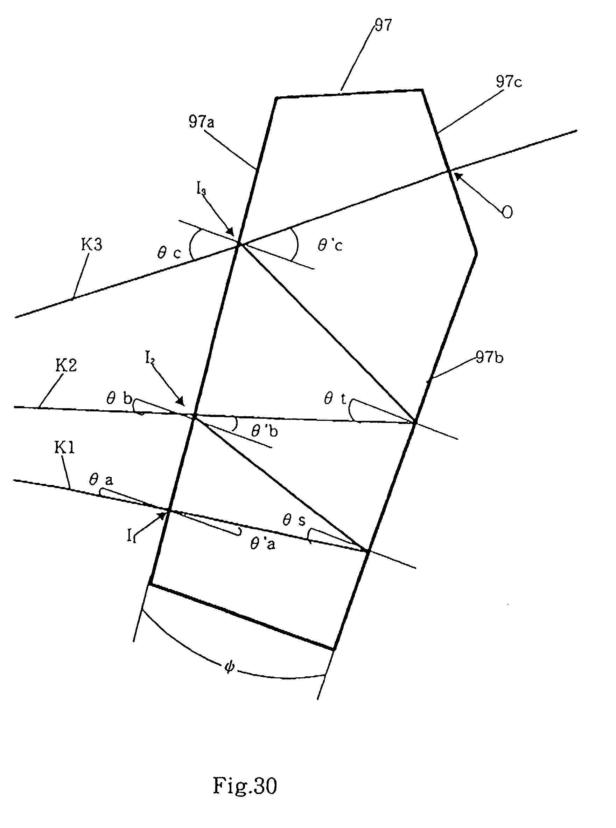

The seventeenth embodiment uses, as shown in FIG. 30, a wedge-shaped prism 97. The incident surface of this wedge-shaped prism is formed with a wavelength selection filter 97a composed of, e.g., dielectric multi-layer film that reflects or transmits the incident laser beam depending on the wavelength and the incident angle thereof.

Further, the exit surface of the wedge-shaped prism is formed with a total reflection layer (reflection part) 97b for reflecting the beams irrespective of the wavelengths, and an antireflection layer (output part) 97c for preventing the reflection.

In the seventeenth embodiment, the prism 97 is inclined so that the laser beams K1, K2, K3 are incident upon the wavelength selection filter 97a at an angle θa, θb, θc respectively, with the wavelengths of the laser beams K1, K2, K3 being set to λa□λb □λc, respectively.

In this case, the first laser beam K1, incident on the first input part $I_1$ of the wavelength selection filter 97a at the angle θa, propagates at the angle θ'a through the prism 97 with the refractive index Np. Then, the first laser beam K1 is reflected at an angle θs (θa + wedge angleΨ) from the total reflection layer 97b (the reflection part) and reaches the second input part $I_2$ for the second laser beam K2.

The second laser beam K2, incident on the second input part $I_2$ of the wavelength selection filter 97a at the angle θb, propagates at the angle θ'b through the prism 97 with the refractive index Np. Since the first laser beam K1 is reflected at the angle θ'b (θs + wedge angled) from the second input part $I_2$ of the wavelength selection filter 97a, the first and second laser beams K1, K2 are synthesized. The synthesized laser beam (K1 + K2) is reflected at an angle θt (θ'b + wedge angleΨ) from the total reflection layer 97b and reaches a third input part $I_3$ for the third laser beam K3.

The third laser beam K3, incident on the third input part $I_3$ of the wavelength selection filter 97a at the angle θc, propagates at the angle θ'c through the prism with the refractive index Np. Since the synthesized laser beam (K1 + K2) is reflected at an angle θ'c (θt + wedge angleΨ) from the third input part $I_3$ of the wavelength selection filter 97a, the third laser beam K3 and the synthesized laser beam (K1 + K2) are synthesized. The synthesized laser beam (K1 + K2 + K3) travels through the output part O formed with the antireflection layer 97c.

Note here in this embodiment that the each beam experiences different times of reflections inside the prism 97, which result in the difference in optical path lengths propagated by each beam. When coupling these beams to a single thread of optical fiber 8, since they have beam waists at different positions with each other, it is difficult to obtain high coupling efficiencies for all of these beams. Therefore, it is required that the optical path length be corrected to be substantially the same.

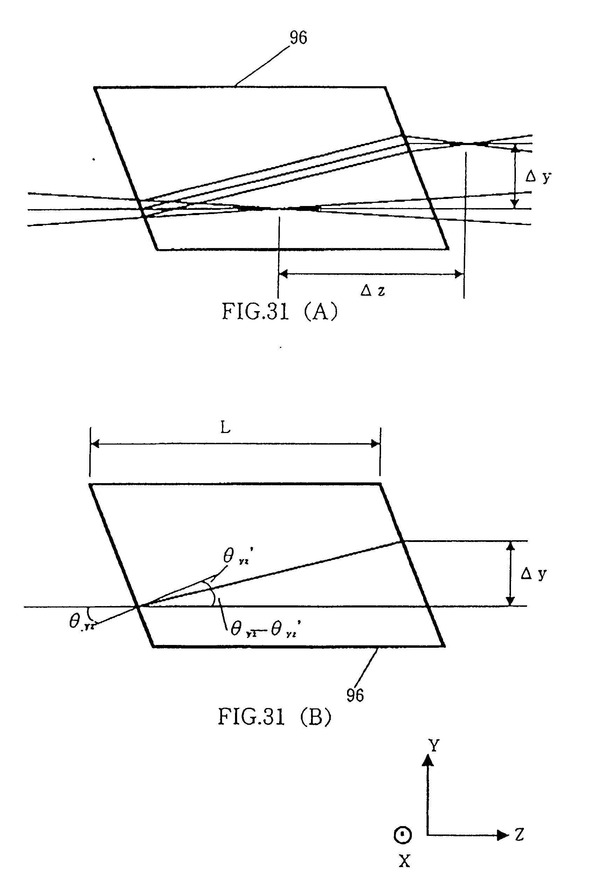

For that purpose, an optical path correction prism 96 for correcting the optical path of the first laser beam K1 is disposed in front of the prism 97 (see FIG.29(A) and FIG. 31).

The optical path correction prism 96 is capable of correcting not only a deviation Δz of the beam waist in the direction of propagation (z-direction) of the Gaussian laser beam emitted from each stripe, but also the deviations Δx, Δy, in the plane perpendicular to the direction of propagation (in the direction of x or y). (Note here that in FIG.31, x-axis orients from face to back of the sheet, y-axis from bottom to top, z-axis from left to right.)

Herein, the following relationships are established for the correction Δy: Sinθyz = Ncsinθyz'

$$\Delta y = L \cdot \tan(\theta yz - \theta yz') / (1 - \tan(\theta yz - \theta yz')\tan\theta yz) \doteqdot L\theta yz \, (rad) \cdot (1 - 1/Nc),$$

where L is the length of the optical path correction prism 96 along the optical axis, θyz is the angle of incidence in the yz-plane, θyz' is the angle of refraction in the same plane, and Nc is the refractive index of the optical path correction prism. Note that the correction Δx can be expressed similarly using angles of incidence and refraction θzx and θzx' which are defined in zx-plane.

Further, the correction Δz can be expressed as :

$$\Delta z \doteqdot (1 - 1/Nc)L$$

The above expressions teaches that the optical path correction prism 96 is capable of correcting not only the optical path length along z-direction (Δz) but also the deviation of the beam which will occur in xy-plane (i.e. of the beam waist; Δx and□Δy), the latter being attained by adjustingly rotating the optical path correction prism 96 around y and x axis.

Thus, according to the seventeenth embodiment, since the optical path correction prism 96 is inserted, the difference in the optical path length can be substantially completely corrected. Similarly, the optical path correction prism 96 may be inserted on the optical path of the second laser beam K2 in order to correct the difference in the optical path length.

Further, according to the seventeenth embodiment, since the optical path correction prism 96 is disposed on the optical path of the laser beam, an optical coupling efficiency to the optical fiber 8 of approximately 80% or more can be obtained for each laser beam even if the maximum allowable manufacturing tolerance of each component is comparatively slackened.

Note that in the seventeenth embodiment, since the first lens 4 functions to widen the divergence between a plurality of laser beams so that they are independent and not overlapping with each other, it is possible to insert an optical path correction prism 96 on the optical path of each laser beam.

The optical module in the seventeenth embodiment is designed based on, e.g., the following numerical values and can be thereby embodied.

(1) The oscillation wavelength of each of the stripes of the semiconductor laser device : $\lambda a$ = 1490 nm, $\lambda b$ = 1470 nm, $\lambda c$ = 1450 nm;

(2) The beam spot size (radius) at the light-exit surface (front edge surface) of the semiconductor laser device : wLD = 1.7 $\mu$m;

(3) The distance between the first stripe 9a and the optical axis C of the first lens 4 : da = - tan$\alpha$a · f2 = -38.4$\mu$m;

(4) The optical path for the second laser beam K2 is aligned to be coincident with the central axis C of the first lens 4;

(5) The distance between the third stripe 9c and the optical axis C of the first lens 4 : dc = - tan$\alpha$c · f2 = 38.6$\mu$m;

(6) The focal length of the first lens 4 : f2 = 720 $\mu$m;

(7) The angle made between the optical axis C of the first lens 4 and the first laser beam K1 : $\alpha a = \theta a - \theta b$ = -3.05°;

(8) The angle made between the optical axis C of the first lens 4 and the third laser beam K3 : $\alpha c = \theta c - \theta a$ = 3.07°;

(9) The parameter of prism 97 : $\Psi$(wedge angle) = 1°, Np = 1.5;

(10) The thickness of the prism 97 in the incident position of the first laser beam K1 : t = 1mm;

(11) The angle of incidence and refraction of the laser beams by the prism 97 : $\theta a$ = 12.050°, $\theta'a$ = 8°, $\theta b$ = 15.10°, $\theta'b$ = 10°, $\theta c$ = 18.17°, $\theta'c$ = 12°;

(12) The interval between the incident positions of the first and second laser beams K1, K2 : $\Delta y1 \fallingdotseq 2(\tan\theta a + \Psi)t \fallingdotseq$ 0.462 mm;

(13) The interval between the incident positions of the second and third laser beams K2, K3 : $\Delta y2 \fallingdotseq 2(\tan\theta a + 2\Psi/\cos^2\theta a + \Psi) t \fallingdotseq$ 0.535 mm;

(14) The distance along the optical axis from the intersecting position of the three beams to the edge surface of the prism 97 : $D \fallingdotseq \Delta y2/ (\theta c - \theta b)$ (rad) = 10.0 mm;

(15) The cut-off wavelengths of the wavelength selection filter 97a : $\lambda x(\theta a)$ = 1502,77 nm, $\lambda x(\theta b)$ = 1483.57 nm, $\lambda x(\theta c)$ = 1460 nm, $\lambda x (0)$ = 1536.62 nm;

With the above-mentioned parameters, the difference in the optical path lengths between the first laser beam K1 and the third laser beam K3 is about 2.5 mm. The optical path correction prism 96 to correct the difference may be, for example, composed of silicon (refractive index Nc =3.4) and 3.5 mm in length (L). Referring to FIG.31, the resulting amount of correction $\Delta z$ is calculated as :

$$\Delta z \fallingdotseq (1 - 1/Nc)\, L \fallingdotseq 2.5 \text{ mm}$$

and the amount of correction $\Delta y$ as :

$$\Delta y = D\, (\theta b - \theta a)\, (rad) - \Delta y1 = 0.070 \text{ mm}$$

with the angle of incidence in the yz-plane $\theta yz \fallingdotseq$ 1.25°.

Note that if the first lens 4 and the second lens 16 are positioned such that the beam spot size therebetween is smaller than in the case of the beam being collimated therebetween, a larger deviation in the intersecting angle $\theta$ of the beams that have traveled through the first lens 4 can be tolerated, whereby a larger manufacturing tolerance in the wedge angle ($\Psi$) of the prism (of$\pm$ 0.05°), and in the spacings (da, dc) of the stripes (of $\pm$ 0.1$\mu$m) are tolerated. Therefore, it becomes possible to position the prism 97 with no severe precision for low loss synthesization to be realized.

In generalizing the sixteenth and seventeenth embodiments, when the laser beams having first to n-th wavelengths are emitted from the first to n-th (n is an integer that is 2 or larger) stripes of the semiconductor laser device 2, the prism 97 includes first to n-th input parts upon which the laser beams of the first through n-th wavelengths are incident, a reflection part for totally reflecting the laser beams, and an output part. The i-th (i includes all the integers of 2 to n) input parts and the reflection part function such that the first to (i-1)th beam entering the light synthesizing element from the first to (i-1)th input part is reflected by the reflection part toward the i-th input part and further reflected by the i-th input part in the traveling direction of the beam of the i-th wavelength, and synthesized with the beam of the i-th wavelength. The thus synthesized beams having the first to n-th wavelengths are coupled to the optical fiber via the output part.

(Eighteenth Embodiment)

An eighteenth embodiment is that of the semiconductor laser module exemplified in one of the first through seventeenth embodiments, as applied to a Raman amplifier.

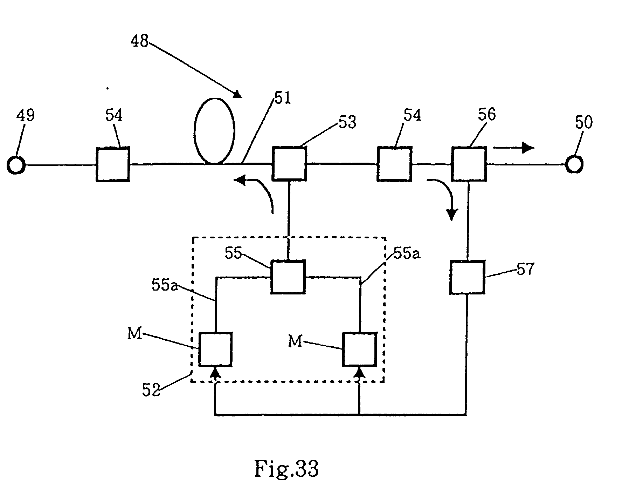

FIG. 33 is a block diagram showing a configuration of the Raman amplifier shown in the eighteenth embodiment of the present invention. This Raman amplifier is used in, e.g., a WDM communication system. As shown in FIG. 33, a Raman amplifier 48 includes an input unit 49 for inputting the signal beam, an output unit 50 for outputting the signal beam, an optical fiber (amplification fiber) 51 through which the signal light is transmitted between the input unit 49 and the output unit 50, a pumping beam generating unit 52 for generating the pumping beam, and a WDM coupler 53 for multiplexing the pumping beam generated by the pumping beam generating unit 52 with the signal beam transmitted through the optical fiber (amplification fiber) 51, and optical isolators 54 that transmit only the signal beam traveling from the input unit 49 toward the output unit 50, are provided between the input unit 49 and the WDM coupler 53 and between the output unit 50 and the WDM coupler 53.

The pumping beam generating unit 52 includes a plurality semiconductor laser modules for emitting the laser beams having wavelength ranges different from each other in the first through seventeenth embodiment, and a WDM coupler 55 for synthesizing the laser beams emitted from the semiconductor laser modules M.

The pumping beams emitted from the semiconductor laser modules M are synthesized by the WDM coupler 55 through a polarization maintaining fiber 55a, and exit the pumping beam generating unit 52.

The pumping beams generated by the pumping beam generating unit 52 are coupled to the optical fiber 51 by the WDM coupler 53. The signal beams inputted from the input unit 49 are multiplexed with the pumping beams and amplified in the optical fiber 51, then travel through the WDM coupler 53 and are outputted from the output unit 50.

The signal beams (amplified signal beams) amplified within the optical fiber 51 are inputted to a monitor beam distribution coupler 56 via the WDM coupler 53 and the optical isolators 54. The monitor beam distribution coupler 56 distributes some portion of the amplified signal beams to a control circuit 57, and the remaining portion of the amplified signal beams are outputted from the output unit 50.

The control circuit 57 controls a laser emission state, e.g., a light intensity of each semiconductor laser module M on the basis of the portion of the_amplified signal beams inputted thereto, and performs feedback control so that a gain of the optical amplification becomes flat over wavelength.

In this Raman amplifier 48, if are used the semiconductor laser modules in which laser beams emitted from the two stripes are polarization-synthesized to have a decreased DOP, it is possible to obtain a high and stable gain with decreased dependency on the polarization of the signal light.

Moreover, if are used the semiconductor laser modules incorporating semiconductor laser devices with diffraction gratings in their stripes, it is possible to reduce the level of noise added to the amplified signal light, due to the decreased relative intensity noise (RIN) compared with the semiconductor laser modules with FBG.

Furthermore, since the semiconductor laser device with the diffraction gratings 75 formed in the stripes has a plurality of longitudinal modes oscillating within the FWHM of the oscillation spectrum, it is possible to obtain stable, low-noise, and high Raman gain without causing stimulated Brillouin scattering.

Further, since the semiconductor laser modules emits laser beams of significantly decreased_DOP and noise, it is possible to obtain a stable gain with decreased dependency on the polarization of the signal light_not only in the backward-pumped Raman amplifier as shown in FIG.33 but also in the forward or bidirectionally pumped Raman amplifier.

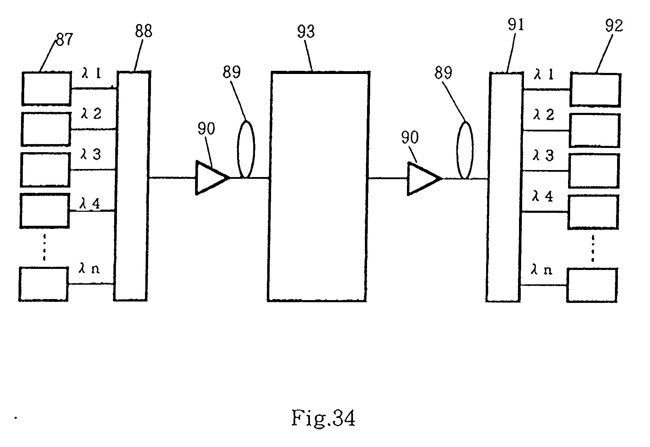

The Raman amplifier shown in FIG. 33 can be, as explained above, applied to the WDM communication system. FIG. 34 is a block diagram showing architecture of the WDM communication system to which the Raman amplifier shown in FIG. 33 is applied.

Referring to FIG. 34, the optical signals having wavelengths λ1 to λn that are transmitted from a plurality of transmitters 87, are multiplexed by an optical multiplexer 88 and converged at one length of optical fiber 89. A plurality of Raman amplifiers 90 each corresponding to the Raman amplifier shown in FIG 33 are disposed depending on the distance on the transmission path of the optical fiber 89, and amplify attenuated optical signals. The signals transmitted on the optical fiber 89 are demultiplexed by an optical demultiplexer 91 into optical signals having the plurality of wavelength λ1 to λn, and received by a plurality of receivers 92. Note that an ADM (Add/Drop Multiplexer) 93 for adding and dropping the optical signal having an arbitrary wavelength might be provided on the transmission path.

The present invention can be modified in many forms within the range of the technical items set forth in the following claims without being limited to the embodiments discussed above.

In the semiconductor laser modules M in the embodiments discussed above, the semiconductor laser device 2 and the holder member 14 are cooled by the same cooling device 20, however, the temperatures of the semiconductor laser device 2 and the holder member 14 may be controlled independently by use of separate cooling devices.

Further, the polarization rotating element involves the use of the half-wave plate 6, however, the polarizing plane may be rotated by use of, for instance, the Faraday element. In this case, the Faraday element is disposed inwardly of the coil, and an intensity of a magnetic field applied to the Faraday element can be varied by changing the electric current flowing through the coil. With this arrangement, a fluctuation in the wavelength of the laser beam and a fluctuation in the rotational angle of the polarizing direction due to a fluctuation in the temperature, can be individually compensated by adjusting the magnitude of the electric current flowing through the coil.

Moreover, it is obvious that the semiconductor laser module in each of the embodiments discussed above can be used as not only the pumping light source for the Raman amplification but also, for example, as the pumping light source for EDFA in 980nm or 1480nm band. Moreover, the semiconductor laser module in each of the embodiments of the present invention can be used as a signal light source.

Further, the number of the stripes formed in the present semiconductor laser device 2 is not limited to 2 or 3 but may be 4 or more.

Obviously, additional numerous modifications and variations of the present invention are possible in light of the above teachings. It is therefore to be understood that within the scope of the appended claims, the present invention may be practiced otherwise than as specifically described herein.

**Claims**

1. A semiconductor laser device (2; 68; 84; 85) comprising:

    a first light emitting stripe (9) having a diffraction grating (75) and aligned to emit a first laser beam (K1) through one edge surface (2a); and
    at least one other light emitting stripe (10) having another diffraction grating (75) and aligned to emit at least one other laser beam (K2)through the one edge surface (2a).

2. The semiconductor laser device according to claim 1, wherein:

    the first light emitting stripe (9) is configured to emit light from the first laser beam through the one edge surface and an opposite edge surface; and
    the least one other light emitting stripe (10) is configured to emit light from the at the least one other laser beam through the one edge surface and the opposite edge surface.

3. The semiconductor laser device according to any one of the preceding claims, wherein:

    the first light emitting stripe (9) and the at least one other light emitting stripe (10) extend parallel to each other.

4. The semiconductor laser device according any one of the preceding claims, wherein:

    the at least one other light emitting stripe (10) includes only a second light emitting stripe (10) in the semiconducting laser device.

5. The semiconductor laser device (2; 68; 84; 85) according to claim 4, wherein:

    the first light emitting stripe (9) and the second light emitting stripe (10) are separated by not more than 100 $\mu$m.

6. The semiconductor laser device according to any one of claimsl to 2 or 4 to 5, wherein:

    the first light emitting stripe and the at least one other light emitting stripe are inclined relative to each other.

7. The semiconductor laser device (2; 68; 84; 85) according to any one of the preceding claims wherein:

    the first light emitting stripe (9) and the at least one other light emitting stripe (10) are configured to be driven simultaneously.

8. The semiconductor laser device according to any one of claims 1 to 6, wherein:

    the first light emitting stripe and the at least one other light emitting stripe are configured to be driven independently.

9. The semiconductor laser device according to any one of the preceding claims, wherein:

the semiconducting laser device is an InP-series buried heterostructure laser.

10. The semiconductor laser device according to any one of claims 1 to 8, wherein:

the semiconducting laser device is a GaAs-series ridge waveguide laser.

11. The semiconductor laser device (2; 68; 84; 85) according to any one of the preceding claims, wherein:

the semiconducting laser device is configured to operate as a pumping light source in an inclusive range of 1300 nm through 1550 nm for a Raman amplifier.

12. The semiconductor laser device (2; 68; 84; 85) according to any one of the preceding claims, wherein:

the semiconducting laser device is configured to operate as a pumping light source in at least one of a 980 nm band and a 1480 nm band for an EDFA.

13. The semiconductor laser device according to any one of the preceding claims, wherein:

at least one of the diffraction grating (75) and the another diffraction grating (75) is disposed uniformly across an entire cavity length of the semidconductor device.

14. The semiconductor laser device according to any one of the preceding claims, wherein:

at least one of the diffraction grating (75) and the another diffraction grating extend along a cavity length (L3; LR) of the semiconductor device in an inclusive range of 800μm through 3200μm and is configured to produce a plurality of longitudinal oscillation wavelengths within a predetermined wavelength band (82).

15. The semiconductor laser device according to any one of the preceding claims, wherein:

at least one of the diffraction grating and the another diffraction grating is disposed uniformly across at least one portion, but not an entire length, of a cavity length of the semiconductor device.

16. The semiconductor laser device according to any one of the preceding claims, wherein:

at least one of the diffraction grating (75) and the another diffraction grating includes at least two periods (C; $\Lambda 1$; $\Lambda 2$).

17. The semiconductor laser device according to any one of the preceding claims, wherein:

the diffraction grating (75) of the first light emitting stripe (9) and the diffraction grating (75) of the at least one other light emitting stripe (10) are configured so that a wavelength (83) emitted by the first light emitting stripe and a wavelength emitted by the at least one other light emitting stripe are substantially the same.

18. The semiconductor laser device according to any one of claims 1 to 16, wherein:

the diffraction grating of the first light emitting stripe (9) and the diffraction grating of the at least one other light emitting stripe (10) are configured so that a wavelength emitted by the first light emitting stripe and a wavelength emitted by the at least one other light emitting stripe are different.

19. The semiconductor laser device according to any of claims 1 to 6 or 8 to 17, wherein:

the first light emitting stripe (9) and the at least one other light emitting stripe (10) are configured to be driven independently in a way that electrically insulates at least one side of a positive pole and a negative pole of the first light emitting stripe and the at least one other light emitting stripe.

20. A single semiconducting laser device, comprising:

means (9) for producing a first laser beam;
means (10) for producing at least one other laser beam; and
means (75) for stabilizing a wavelength in the first laser beam and the at least one other laser beam.

**21.** A single semiconducting laser device according to claim 20, further comprising:

means for producing the first laser beam and the at least one other laser beam each with a plurality of longitudinal oscillation wavelengths (83) within a predetermined wavelength band (82).

**22.** A single semiconducting laser device according to any one of claims 20 to 21, further comprising:

means for emitting the first laser beam and the at least one other laser beam with a wavelength substantially the same.

**23.** A single semiconducting laser device according to any one of claims 20 to 21, further comprising:

means for emitting the first laser beam and the at least one other laser beam with a different wavelength.

**24.** A single semiconducting laser device according to any one of claims 20 to 23, further comprising:

means for driving the first laser beam and the at least one other laser beam with a common power source.

**25.** A single semiconducting laser device according to any one of claims 20 to 23, further comprising:

means for driving the first laser beam and the at least one other laser beam with different power sources.

**26.** An optical amplifier (48) comprising:

a pump beam generator having (52) a plurality of semiconductor laser modules configured to emit multiplexed laser beams, with each of the plurality of semiconductor laser modules having
    a single semiconductor laser device including
        a first light emitting stripe (9) with a diffraction grating (75) and aligned to emit a first laser beam (K1) through one edge surface (2a), and
        at least one other light emitting stripe (10) having another diffraction grating (75) and aligned to emit at least one other laser beam (K2) through the one edge surface (2a), and
        an optical fiber (8; 55a) positioned to receive a multiplexed laser beam produced therein; and
    a wave division multiplex coupler (55) configured to synthesize the multiplexed laser beams emitted by the plurality of semiconductor laser modules (M).

**27.** The optical amplifier according to claim 26, wherein:

the plurality of semiconductor laser modules (M) are each configured to emit the multiplexed laser beam at different control wavelengths.

**28.** The optical amplifier according to any one of claims 26 to 27, wherein:

the pump beam generator (52) is coupled to an amplification medium by a wave division multiplex coupler (53).

**29.** The optical amplifier according to any one of claims 26 to 28, wherein:

said optical amplifier (48) is configured for Raman amplification.

**30.** The optical amplifier according to any one of claims 26 to 29, wherein:

the pump beam generator (52) is coupled to a control mechanism including a monitor beam distribution (56) coupler coupled to an amplification medium and a control circuit (57) connected between the monitor beam distribution coupler and the pump beam generator, wherein the control mechanism is configured to control the output of the plurality of semiconductor laser modules.

**31.** The optical amplifier according to any one of claims 26 to 30, wherein:

the semiconductor laser module further includes
a first lens (4) positioned so that the first laser beam and the at least one other laser beam emitted from the semiconductor laser device (2; 68; 84; 85) are incident thereon, the first lens configured to further separate the first laser beam and the at least one other laser beam, and
a beam synthesizing member (7) including
a first input part (7a) on which the first laser beam is incident,
at least one other input part (7b) on which the at least one other laser beam is incident, and
an output part (7c) from which the first laser beam emerging from the first input part and the at least one other laser beam emerging from the at least one other input part are multiplexed and emitted as a multiplexed laser beam.

**32.** A semiconductor laser module (M; M1; M2; M3), comprising:

a single semiconductor laser device having a first light emitting stripe (9) with a diffraction grating (75) and aligned to emit a first laser beam (K1) through one edge surface and at least one other light emitting stripe (10) having a diffraction grating (75) and aligned to emit at least one other laser beam (K2) through the one edge surface;
a first lens (4) positioned so that the first laser beam and the at least one other laser beam emitted from the semiconductor laser device are incident thereon, the first lens configured to further separate the first laser beam and the at least one other laser beam;
a beam synthesizing module (59) including a prism (5) and a beam synthesizing member (7) having
a first input part (7a) on which the first laser beam is incident,
at least one other input part (7b) on which the at least one other laser beam is incident, and
an output part (7c)from which the first laser beam emerging from the first input part and the at least one other laser beam emerging from the at least one other input part are multiplexed and emitted as a multiplexed laser beam; and
an optical fiber (8; 55a) positioned to receive the multiplexed laser beam therein.

**33.** The semiconductor laser module according to claim 32, further comprising:

an optical isolator (94) positioned between the first lens and the beam synthesizing member where the first laser beam and the at least one other laser beam are parallel relative to each other, wherein the optical isolator is configured to stabilize the semiconductor module by preventing a laser beam reflection.

**34.** The semiconductor laser module according to any one of claims 32 to 33, further comprising:

a cooling device (20) configured to cool the semiconductor laser device (2; 68; 84; 85); and
a base plate module having a first base plate (17) on which the semiconductor laser device is fixed and a second base plate (18) disposed onto the first base plate and on which the beam synthesizing member is fixed.

**35.** The semiconductor laser module according to any one of claims 32 to 34, further comprising:

a second lens (16) configured to couple the multiplexed laser beam to the optical fiber (8;55a).

M1

1c

12  20a  13  59  5  6  7  1b  1d  16  21  22  23

3  2  4  19b

19a  14  8

11  17  17a  18  20  1a  1

Y

⊙
X

Z

Fig.1 (A)

2

58

11

Fig.1 (B)

Fig.2

L1

5

5b

5a

Fig.3 (A)

5b

5

α

5a

α

5b

Fig.3 (B)

Fig.4 (A)

Fig.4 (B)

Fig.4 (C)

FIG. 5

Fig.6

Fig.7 (A)

Fig.7 (B)

Fig.8 (A)

Fig.8 (B)

Fig.8 (C)

Fig.9

Fig.10

Fig.11

Fig.12

Fig.13

Fig.14

Fig.15 (A)

Fig.15 (B)

Fig.15 (C)

Fig.16

Fig.17 (B)

WAVELENGTH

LIGHT INTENSITY

Fig.17 (A)

WAVELENGTH

LIGHT INTENSITY

Pth

Fig.18 (A)

84a

73
72
75
71
LG1
70
69
80
81
LR

Fig.18 (B)

84b

75
73
72
71
LG2
70
69
80
81
LR

Fig.18 (C)

84c

75
73
72
75
71
LG4   LG3
70
69
80
81
LR

Fig.19

Fig. 20

Fig.21 (A)

Fig.21 (B)

Fig.21 (C)

Fig.22 (A)

Fig.22 (B)

Fig.23

Fig.24

Fig.25

Fig.26 (A)

Fig.26 (B)

Fig.26 (C)

Fig.27 (A)

Fig.27 (B)

Fig.27 (C)

WAVELENGTH

Fig.28

FIG.29 (A)

FIG.29 (B)

Fig.30

96

FIG.31 (A)

$\Delta y$

$\Delta z$

L

$\theta_{yz}'$

$\theta_{yz}$

$\theta_{yz} - \theta_{yz}'$

$\Delta y$

96

FIG.31 (B)

Y

Z

X

FIG.32

Fig.33

Fig.34

Fig.35